# EUROPEAN PATENT APPLICATION

(11) **EP 4 350 909 A1**
(43) Date of publication of application: **10.04.2024**
(21) Application number: 22816002.4
(22) Date of filing: 27.05.2022
(51) Int. Cl.: H01S 5/183, H01L 21/20, H01L 21/205

(54) **SEMICONDUCTOR DEVICE, SEMICONDUCTOR DEVICE MANUFACTURING METHOD AND MANUFACTURING APPARATUS, AND ELECTRONIC APPARATUS**

(30) Priority: 31.05.2021 JP 2021091626
(71) Applicant: Kyocera Corporation, Kyoto-shi Kyoto 612-8501 (JP)
(72) Inventor: KAMIKAWA, Takeshi, Kyoto-shi, Kyoto 612-8501 (JP); KAWAGUCHI, Yoshinobu, Kyoto-shi, Kyoto 612-8501 (JP); TANIGUCHI, Yuki, Kyoto-shi, Kyoto 612-8501 (JP)
(74) Representative: Viering, Jentschura & Partner mbB Patent- und Rechtsanwälte
(86) International application number: PCT/JP2022/021754
(87) International publication number: WO 2022/255252

(57) **Abstract**

A semiconductor device includes a base substrate (UK), a first light reflector (RF) located above the base substrate (UK), a first mask (6) located above the first light reflector (RF), a base semiconductor part (8) located above the first mask (6), a compound semiconductor part (9) located above the base semiconductor part (8), and a second light reflector (RS) located above the compound semiconductor part (9) and the first light reflector (RF).

## Description

### TECHNICAL FIELD

The present disclosure relates to a semiconductor device and the like.

### BACKGROUND OF INVENTION

Patent Document 1 discloses a surface emitting semiconductor laser element in which a distributed Bragg reflector (DBR) layer and a light-emitting layer are provided on a GaN substrate. The structure using the DBR as a selective growth mask has heat dissipation problems.

### CITATION LIST

### PATENT LITERATURE

### Patent Document 1: JP 6555260 B

### SUMMARY

A semiconductor device according to the present disclosure includes a base substrate including a main substrate, a first light reflector located above the base substrate, a first mask located above the first light reflector, a base semiconductor part located above the first mask, a compound semiconductor part located above the base semiconductor part, and a second light reflector located above the compound semiconductor part and the first light reflector.

### BRIEF DESCRIPTION OF THE DRAWINGS

FIG. 1 is a cross-sectional view illustrating the configuration of a semiconductor device according to the present embodiment.
FIG. 2 is a cross-sectional view illustrating another configuration of the semiconductor device according to the present embodiment.
FIG. 3 is a flowchart illustrating an example of a method for manufacturing a semiconductor device according to the present embodiment.
FIG. 4 is a block diagram illustrating an example of an apparatus for manufacturing the semiconductor device according to the present embodiment.
FIG. 5 is a cross-sectional view of a semiconductor device along an X-direction according to Example 1.
FIG. 6 is a cross-sectional view of the semiconductor device along a Y-direction according to Example 1.
FIG. 7 is a plan view of the semiconductor device according to Example 1.
FIG. 8 is a partial enlarged view of the semiconductor device according to Example 1.
FIG. 9 is a partial enlarged view of the semiconductor device according to Example 1.
FIG. 10 is a cross-sectional view illustrating a configuration example of a base substrate.
FIG. 11 is a cross-sectional view illustrating another configuration example around a first light reflector.
FIG. 12 is a cross-sectional view illustrating another configuration example around the first light reflector.
FIG. 13 is a cross-sectional view illustrating another configuration example around the first light reflector.
FIG. 14 is a flowchart illustrating an example of a method for manufacturing the semiconductor device according to Example 1.
FIG. 15 illustrates cross-sectional views of an example of the method for manufacturing the semiconductor device according to Example 1.
FIG. 16 illustrates cross-sectional views of an example of lateral growth of a base semiconductor part 8.
FIG. 17 is a plan view illustrating another configuration of the semiconductor device according to Example 1.
FIG. 18 is a cross-sectional view illustrating another configuration of the semiconductor device according to Example 1.
FIG. 19 is a plan view illustrating another configuration of the semiconductor device according to Example 1.
FIG. 20 is a cross-sectional view illustrating another configuration of the semiconductor device according to Example 1.
FIG. 21 is a cross-sectional view illustrating another configuration of the semiconductor device according to Example 1.
FIG. 22 is a cross-sectional view illustrating another configuration of the semiconductor device according to Example 1.
FIG. 23 is a cross-sectional view illustrating another configuration of the semiconductor device according to Example 1.
FIG. 24 is a cross-sectional view illustrating another configuration of the semiconductor device according to Example 1.
FIG. 25 is a cross-sectional view illustrating another configuration of the semiconductor device according to Example 1.
FIG. 26 is a cross-sectional view illustrating another configuration of the semiconductor device according to Example 1.
FIG. 27 is a plan view illustrating another configuration of the semiconductor device according to Example 1.
FIG. 28 is a plan view illustrating another configuration of the semiconductor device according to Example 1.
FIG. 29 is a schematic plan view illustrating another configuration of the semiconductor device according to Example 1.
FIG. 30 is a schematic plan view illustrating another configuration of the semiconductor device according to Example 1.
FIG. 31 is a cross-sectional view illustrating a configuration of a semiconductor device according to Example 2.
FIG. 32 is a cross-sectional view illustrating a configuration of the base substrate according to Example 2.
FIG. 33 is a cross-sectional view illustrating a configuration of the base substrate according to Example 2.
FIG. 34 is a cross-sectional view illustrating a configuration of the base substrate according to Example 2.
FIG. 35 is a cross-sectional view illustrating a configuration of the base substrate according to Example 2.
FIG. 36 is a cross-sectional view illustrating a configuration of a semiconductor device according to Example 3.
FIG. 37 is a cross-sectional view illustrating the configuration of the semiconductor device according to Example 3.
FIG. 38 is a flowchart illustrating an example of a method for manufacturing a semiconductor device according to Example 4.
FIG. 39 is a cross-sectional view illustrating a configuration of the semiconductor device according to Example 4.
FIG. 40 is a cross-sectional view illustrating a configuration of the semiconductor device according to Example 4.
FIG. 41 is a flowchart illustrating another example of the method for manufacturing the semiconductor device according to Example 4.
FIG. 42 is a cross-sectional view illustrating another configuration of the semiconductor device according to Example 4.
FIG. 43 is a cross-sectional view illustrating another configuration of a semiconductor device according to Example 8.
FIG. 44 is a cross-sectional view illustrating another configuration of the semiconductor device according to Example 8.
FIG. 45 is a cross-sectional view illustrating another configuration of a semiconductor device according to Example 9.
FIG. 46 is a schematic diagram illustrating a configuration of an electronic device according to Example 10.

### DESCRIPTION OF EMBODIMENTS

### Semiconductor Device

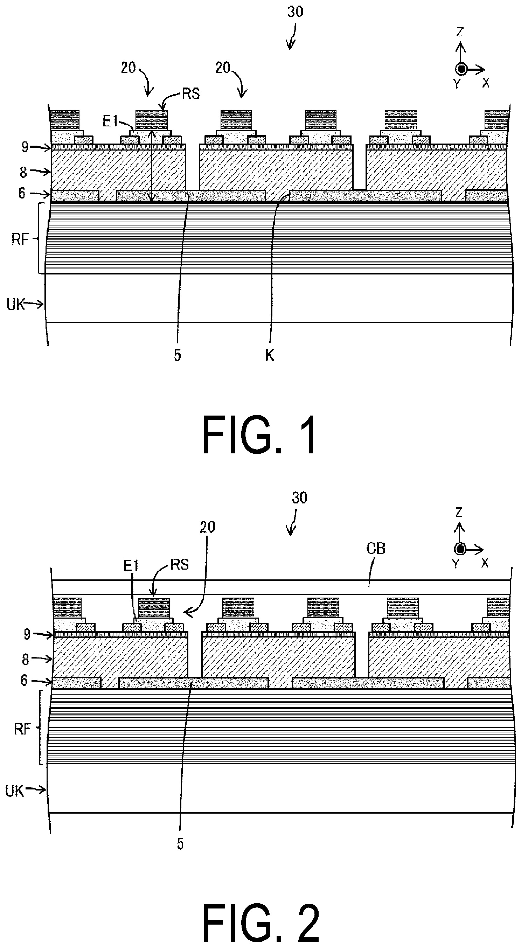

FIG. 1 is a cross-sectional view illustrating a configuration of a semiconductor device according to the present embodiment. As illustrated in FIG. 1, a semiconductor device 30 according to the present embodiment includes a base substrate UK, a first light reflector RF located above the base substrate UK, a first mask 6 located above the first light reflector RF, a base semiconductor part 8 located above the first mask 6, a compound semiconductor part 9 located above the base semiconductor part 8, and a second light reflector RS located above the compound semiconductor part 9 and the first light reflector RF.

The semiconductor device 30 includes one or more surface emitting semiconductor laser elements 20 each including the base semiconductor part 8, the compound semiconductor part 9, the first light reflector RF, and the second light reflector RS. Here, the normal direction of the base substrate UK, that is, the direction from the base substrate UK toward the first mask 6 is referred to as an upward direction. In the semiconductor device 30, the first mask 6 may be a mask layer 6, the base semiconductor part 8 may be a base semiconductor layer 8, the compound semiconductor part 9 may be a compound semiconductor layer 9, the first light reflector RF may be a first light reflector layer, and the second light reflector RS may be a second light reflector layer. The first mask 6 may include a mask portion 5 and an opening portion K. That is, the first mask 6 may be a mask pattern including the mask portion 5 and the opening portion K.

A first electrode E1 can be provided on the compound semiconductor part 9. The first light reflector RF, the base semiconductor part 8, the compound semiconductor part 9, the first electrode E1, and the second light reflector RS may overlap each other in plan view. Two components overlapping each other in plan view means that at least a part of one component overlaps the other component when viewed (including perspective viewing) in the normal direction of the base substrate UK.

In the semiconductor device 30, laser oscillation is enabled when the light generated in the compound semiconductor part 9 reciprocates between the first and second light reflectors RF and RS. In the semiconductor device 30, the first light reflector RF provided between the base substrate UK and the first mask 6 increases heat dissipation from the first light reflector RF, and improves the reliability of the surface emitting semiconductor laser element 20.

The base semiconductor part 8 and the compound semiconductor part 9 may include a nitride semiconductor. The nitride semiconductor may be expressed, for example, by AlₓGa_{y}In_{z}N (0 ≤ x ≤ 1; 0 ≤ y ≤ 1; 0 ≤ z ≤ 1; x + y + z = 1). Specific examples of the nitride semiconductor may include a GaN-based semiconductor, aluminum nitride (AlN), indium aluminum nitride (InAlN), and indium nitride (InN). The GaN-based semiconductor is a semiconductor containing gallium atoms (Ga) and nitrogen atoms (N). Typical examples of the GaN-based semiconductor may include GaN, AlGaN, AlGaInN, and InGaN. The base semiconductor part 8 may be of a doped type (for example, an n-type including a donor). Each of the base semiconductor part 8 and the compound semiconductor part 9 may be a nitride semiconductor layer.

The base semiconductor part 8 including the nitride semiconductor can be formed by an epitaxial lateral overgrowth (ELO) method. The use of the ELO method decreases the number of threading dislocations (defects) in the base semiconductor part 8 and the compound semiconductor part 9 on the mask portion 5, thus enhancing the light emission efficiency of the compound semiconductor part 9 (for example, the ratio of the amount of light to the amount of charge injected from the first electrodes E1) while reducing the amount of heat generation. This is due to the fact that the threading dislocations are dislocations (defects) that extend from the base semiconductor part 8 to the compound semiconductor part 9, suppressing charge transfer and causing heat generation.

When the base semiconductor part 8 is formed using the ELO method, a template substrate including the base substrate UK, the first light reflector RF, and the mask pattern 6 on the first light reflector RF may be used. The template substrate may include a growth suppression region (for example, a region that suppresses crystal growth in the Z-direction) corresponding to the mask portion 5 and a seed region corresponding to the opening portion K. For example, the growth suppression region and the seed region may be formed in the first light reflector RF, and the base semiconductor part 8 may be formed on the growth suppression region and the seed region using the ELO method.

The first light reflector RF may be the epitaxial distributed Bragg reflector (DBR) including a nitride semiconductor. This increases the light reflectance of the first light reflector RF.

FIG. 2 is a cross-sectional view illustrating another configuration of the semiconductor device according to the present embodiment. As illustrated in FIG. 2, the semiconductor device 30 can be configured to include a circuit board CB located on the opposite side of the base substrate UK (above the compound semiconductor part 9) and electrically connected to the surface emitting semiconductor laser element 20.

### Manufacturing Semiconductor Device

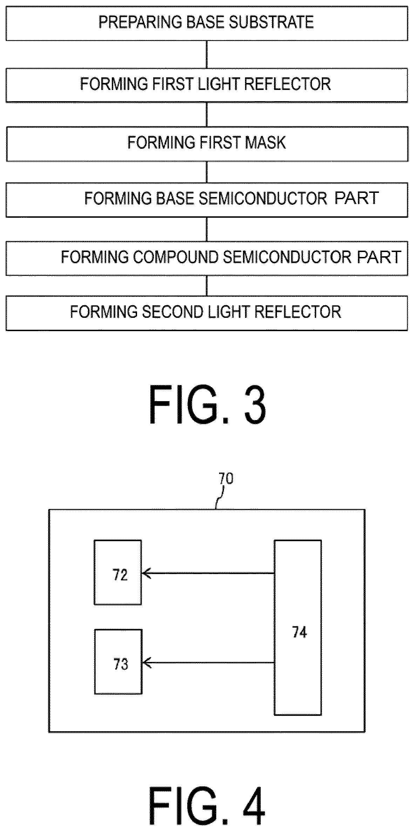

FIG. 3 is a flowchart illustrating an example of a manufacturing method for manufacturing a semiconductor device according to the present embodiment. The method for manufacturing the semiconductor device illustrated in FIG. 3 includes preparing the base substrate UK, forming the first light reflector RF, forming the first mask 6, forming the base semiconductor part 8 using the ELO method, forming the compound semiconductor part 9, and forming the second light reflector RS.

FIG. 4 is a block diagram illustrating an example of an apparatus for manufacturing the semiconductor device according to the present embodiment. A semiconductor device 70 in FIG. 4 includes a first film forming unit 72 configured to form the first light reflector RF, the base semiconductor part 8, and the compound semiconductor part 9, a second film forming unit 73 configured to form the first mask 6 and the second light reflector RS, and a control unit 74 configured to control the first and second film forming units 72 and 73.

The first film forming unit 72 may include a metal organic chemical vapor deposition (MOCVD) apparatus, and the control unit 74 may include a processor and a memory. The control unit 74 may be configured to control the first and second film forming units 72, 73 by executing a program stored in, for example, a built-in memory or a communicable communication device, or on an accessible network. The program and a recording medium or the like in which the program is stored are also included in the present embodiment.

### Example 1

### Overall Configuration

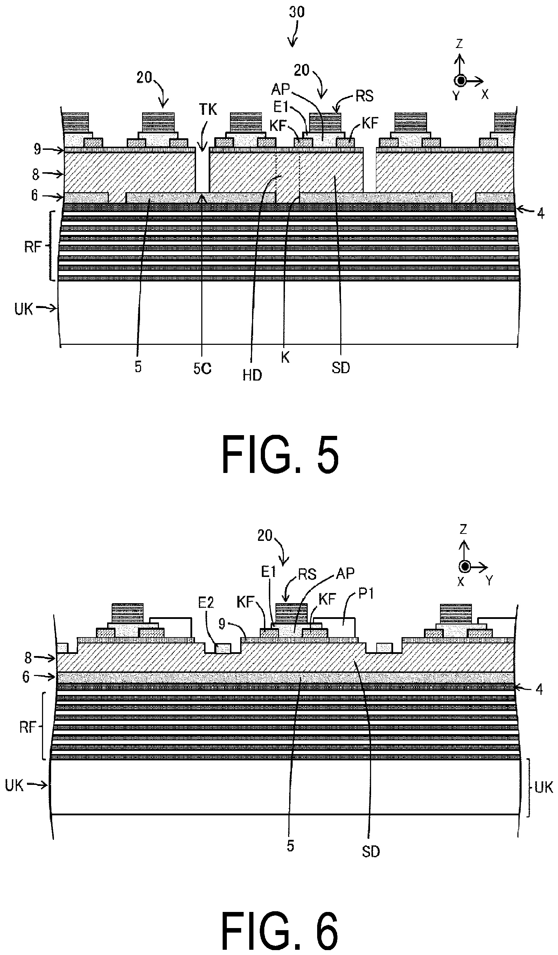

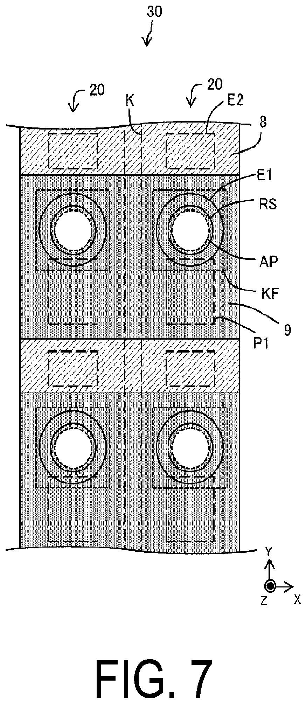

FIG. 5 is a cross-sectional view of the semiconductor device in the X-direction according to Example 1. FIG. 6 is a cross-sectional view of the semiconductor device in the Y-direction according to Example 1. FIG. 7 is a plan view of the semiconductor device according to Example 1. As illustrated in FIGs. 5, 6, and 7, the semiconductor device 30 according to Example 1 includes the base substrate UK, the first light reflector RF located on the base substrate UK, the seed portion 4 located on the first light reflector RF, the first mask 6 located on the seed portion 4 and including the mask portion 5 and the opening portion K, the base semiconductor part 8 located on the first mask 6, the compound semiconductor part 9 located on the base semiconductor part 8, an insulating film KF located on the compound semiconductor part 9, the first electrode E1 located on the compound semiconductor part 9, the second electrode E2 located on the base semiconductor part 8, and the second light reflector RS located on the first electrode E1. The base semiconductor part 8 and the compound semiconductor part 9 may include nitride semiconductors (for example, GaN-based semiconductors). The X-direction is the <11-20> direction of the base semiconductor part 8, the Y-direction is the <1-100> direction of the base semiconductor part 8, and the Z-direction is the <0001> direction of the base semiconductor part 8.

The base semiconductor part 8 includes a first portion HD and a second portion SD (low-defect portion) which is located on the mask portion 5 and having a threading dislocation density of one fifth or less of the first portion HD. The threading dislocation density of the second portion SD may be 5 x 10⁶/cm² or less. The second portion SD overlaps the compound semiconductor part 9 in plan view. A part of the compound semiconductor part 9 that overlaps the second portion SD in plan view is a low dislocation portion taking over the low dislocation characteristic (low-defect characteristic) of the base semiconductor part 8. The first light reflector RF and the second light reflector RS can be configured to overlap the second portion SD in plan view. The base semiconductor part 8 can be made of an n-type semiconductor (for example, silicon-doped gallium nitride). For example, when the mask portion 5 contains silicon, the base semiconductor part 8 can be the n-type semiconductor by diffusing a part of the first mask 6 while the base semiconductor part 8 is formed by unintentional doping.

In FIGs. 5 and 6, the first electrode E1 is a translucent anode, and the second electrode E2 is a cathode. The first electrode E1 is located above the compound semiconductor part 9 and overlaps the second light reflector RF in plan view. The second electrode E2 is located above the first mask 6 and does not overlap the second light reflector RS in plan view. The second electrode E2 is in contact with the base semiconductor part 8. The compound semiconductor part 9 is provided on the base semiconductor part 8, but the compound semiconductor part 9 is not formed above a part of the base semiconductor part 8. The second electrode E2 is provided so as to be in contact with the part of the base semiconductor part 8.

The semiconductor device 30 includes one or more vertical cavity surface emitting semiconductor laser elements 20 (VCSEL: vertical cavity surface emitting elements), each including the first light reflector RF, the base semiconductor part 8, the compound semiconductor part 9, the insulating film KF, the first and second electrodes E1, E2, and the second light reflector RS. In the semiconductor laser element 20, the light generated in the compound semiconductor part 9 by the current between the first and second electrodes E1, E2 oscillates in the laser due to induced emission and feedback effects between the first and second light reflectors RF, RS.

In the semiconductor device 30, the first light reflector RF provided between the base substrate UK and the first mask 6 increases heat dissipation from the first light reflector RF, and improves the reliability of the surface emitting semiconductor laser element 20. This also increases the degree of freedom of design (material, structure, and the like) of the base substrate UK and the first light reflector RF.

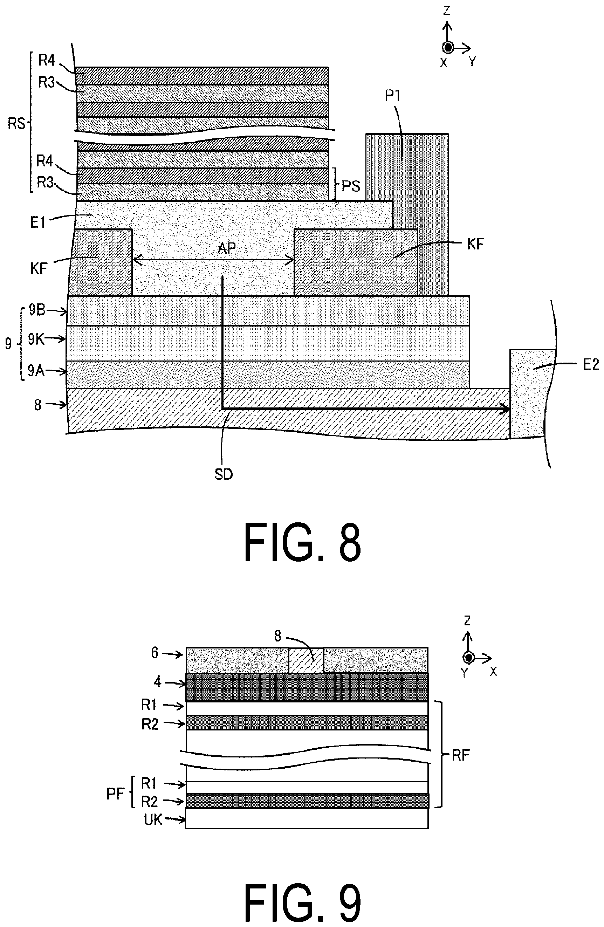

FIG. 8 is a partial enlarged view of the semiconductor device of Example 1. As illustrated in FIG. 8, the compound semiconductor part 9 includes an n-type semiconductor layer 9A as a first-type semiconductor layer, an active layer 9K, and a p-type semiconductor layer 9B as a second-type semiconductor layer in this order from the lower layer side. The active layer 9K has a multi-quantum well (MQW) structure and includes, for example, InGaN and/or GaN. The n-type semiconductor layer 9A is, for example, an n-type AlGaN layer. The p-type semiconductor layer 9B is, for example, a p-type GaN layer. The first electrode E1 serving as the anode is provided so as to be in contact with the p-type semiconductor layer 9B.

The semiconductor device 30 includes the insulating film KF located on the compound semiconductor part 9. The insulating film KF includes an aperture portion AP overlapping the first electrode E1, the first light reflector RF, the second portion SD, and the second light reflector RS in plan view. The first electrode E1 is a transparent electrode located between the compound semiconductor part 9 and the second light reflector RS, and the first electrode E1 is in contact with the upper surface of the insulating film KF. For the insulating film KF, SiOx, SiNx, AlOx, or the like can be used.

In the aperture portion AP, the first electrode E1 is in contact with the compound semiconductor part 9. Specifically, the p-type semiconductor layer 9B exposed from the aperture portion AP is in contact with the central portion of the first electrode E1. The aperture portion AP is a current constriction portion formed by, for example, circularly penetrating the insulating film KF. The aperture portion AP constricts the current path between the first and second electrodes E1, E2 on the anode side, thus enhancing the light emission efficiency.

In Example 1, the aperture portion AP overlaps the second light reflector RS, the compound semiconductor part 9, the second portion SD (low-defect portion) of the base semiconductor part 8, and the first light reflector RF in plan view. This allows generation of the current path extending from the first electrode E1 in the aperture portion AP to the base semiconductor part 8 through the compound semiconductor part 9 at the low-defect portion of the base semiconductor part 8 and the compound semiconductor part 9. This enhances the light emission efficiency in the active layer 9K, while suppressing the heat generation in the base semiconductor part 8 and the compound semiconductor part 9.

In the semiconductor device 30, a first pad P1 is provided in contact with the first electrode E1, and the first pad P1, the aperture portion AP, and the second electrode E2 are arranged in the Y-direction in plan view. This allows the second electrode E2 to be formed on the second portion SD (low-defect portion) of the base semiconductor part 8, enhancing the light emission efficiency in the active layer 9K. The first pad P1 only needs to be in contact with a part of the first electrode E1, but may be shaped such that the first pad P1 is in contact with the periphery of the first electrode E1 (that is, a region contacting the first electrode E1 surrounds the aperture portion AP in plan view) in order to inject the current more uniformly into the aperture portion AP. The first pad P1 may be circular.

FIG. 9 is a partial enlarged view of the semiconductor device of Example 1. The first light reflector RF is located on the base substrate UK and can be an epitaxial DBR including a nitride semiconductor. In this case, as illustrated in FIG. 9, the first light reflector RF includes a plurality of pairs PF, each including a first refractive portion R1 and a second refractive portion R1 having a light refractive index larger than that of the first refractive portion R2. The second refractive portion R2 may include a GaN-based semiconductor, and the first refractive portion R1 may include a refractive material (for example, a nitride semiconductor) having a light refractive index smaller than that of the GaN-based semiconductor of the second refractive portion R2. In FIG. 6, the seed portion 4 is provided between the first light reflector RF and the first mask 6. Specifically, the upper surface of the first light reflector RF is included in the first refractive portion R1, the seed portion 4 including, for example, the GaN-based semiconductor is formed on the first light reflector RF, and the first mask 6 is formed on the seed portion 4. The base semiconductor part 8 located on the first mask 6 may have a light refractive index larger than that of the mask portion 5. The seed portion 4 may have a light refractive index larger than that of the mask portion 5 and the first refractive portion R1.

The first light reflector RF formed as the epitaxial DBR including a nitride semiconductor increases the light reflectance of the first light reflector RF and simplifies the manufacturing process. This also relaxes the stress (tensile stress at room temperature) of the base semiconductor part 8.

The second light reflector RS may be located on the first electrode E1 and may be a dielectric DBR including a dielectric body. In this case, as illustrated in FIG. 8, the second light reflector RS includes a plurality of pairs PS each including a third refractive portion R3 and a fourth refractive portion R4 having a light refractive index larger than that of the third refractive portion R3, and each of the third refractive portion R3 and the fourth refractive portion R4 includes a dielectric material.

The lower surface of the second light reflector RS may be included in the third refractive portion R3, and the upper surface of the second light reflector RS may be included in the fourth refractive portion R4. The third refractive portion R3 may have a light refractive index smaller than that of the p-type semiconductor layer 9B. This increases the light reflectance of the second light reflector RS. The second light reflector RS provided in an island shape on the first electrode E1 increases the heat dissipation.

As illustrated in FIGs. 5 and 6, the semiconductor device 30 of Example 1 includes a gap TK which is in contact with the side surface of the base semiconductor part 8, the side surface of the compound semiconductor part 9, and the side surface of the second light reflector RS, and the gap TK and the center 5C of the mask portion 5 overlap in plan view. The side surfaces of the base semiconductor part 8 and the compound semiconductor part 9 may each be an a-plane or an m-plane of the GaN-based semiconductor. Providing the gap TK increases the heat dissipation and relaxes the stress of the base semiconductor part 8.

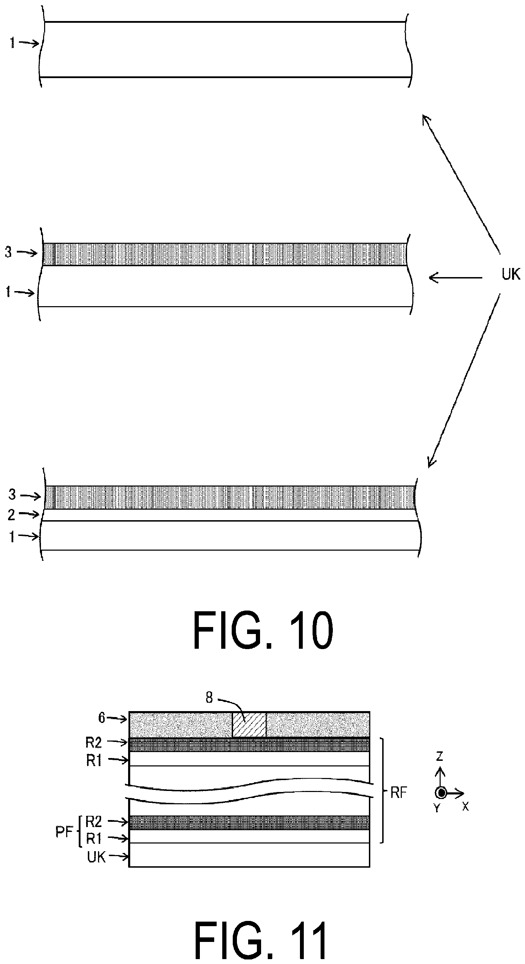

FIG. 10 illustrates cross-sectional views of a configuration example of the base substrate. As illustrated in FIG. 10, the base substrate UK may be constituted by a main substrate 1. In this case, for example, a SiC substrate (6H-SiC bulk crystal), a GaN substrate (bulk crystal), or an AlN substrate (bulk crystal) can be used as the main substrate 1. Alternatively, the base substrate UK may include the main substrate 1 and a base portion 3 located above the main substrate 1. In this case, for example, a SiC substrate can be used as the main substrate 1 and a nitride semiconductor (for example, a GaN-based semiconductor) can be used for the base portion 3; an AlN substrate can be used as the main substrate 1, and the nitride semiconductor (for example, a GaN-based semiconductor) can be used for the base portion 3; a Si substrate (bulk crystal) can be used as the main substrate 1, and aluminum nitride (AlN) or silicon carbide (SiC) can be used for the base portion 3; or a GaN substrate (bulk crystal) can be used as the main substrate 1, and GaN can be used for the base portion 3. The base substrate UK may include the main substrate 1, a buffer portion 2 located above the main substrate 1, and the base portion 3 located above the buffer portion 2. In this case, for example, a SiC substrate or a Si substrate can be used as the main substrate 1, AlN (aluminum nitride) and/or SiC (silicon carbide) can be used for the buffer portion 2, and a nitride semiconductor (for example, a GaN-based semiconductor) can be used for the base portion 3.

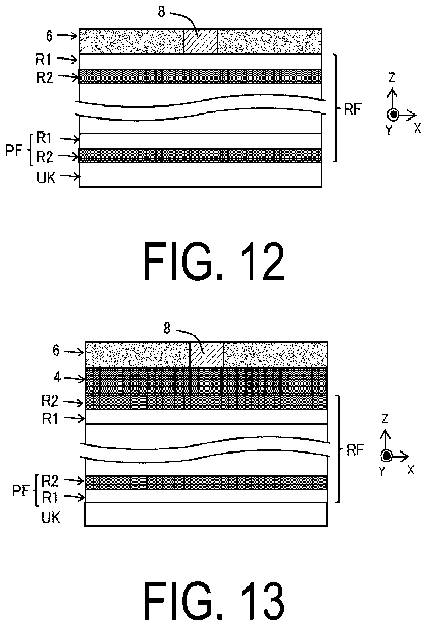

FIGs. 11 to 13 are cross-sectional views each illustrating another configuration example around the first light reflector. In FIG. 11, the upper surface of the first light reflector RF is included in the second refractive portion R2, and the first mask 6 is formed on the first light reflector RF. In this case, the uppermost second refractive portion R2 functions as a seed when the base semiconductor part 8 is laterally grown, and the base semiconductor part 8 is in contact with the upper surface of the first light reflector RF in the opening portion K of the first mask 6. In FIG. 12, the upper surface of the first light reflector RF may be included in the first refractive portion R1, and the first mask 6 may be formed on the first light reflector RF. In this case, the uppermost first refractive portion R1 including, for example, a nitride semiconductor functions as a seed when the base semiconductor part 8 is laterally grown, and the base semiconductor part 8 is in contact with the upper surface of the first light reflector RF in the opening portion K of the first mask 6. In FIG. 13, the seed portion 4 is provided between the first light reflector RF and the first mask 6. Specifically, the upper surface of the first light reflector RF is included in the second refractive portion R2, the seed portion 4 including, for example, a nitride semiconductor is formed on the first light reflector RF, and the first mask 6 is formed on the seed portion 4. In addition, the use of the same material (for example, a GaN-based semiconductor) to form the uppermost layer of the first light reflector RF or the seed portion 4, and the base semiconductor part 8 can simplify the manufacturing process.

### Manufacturing Method

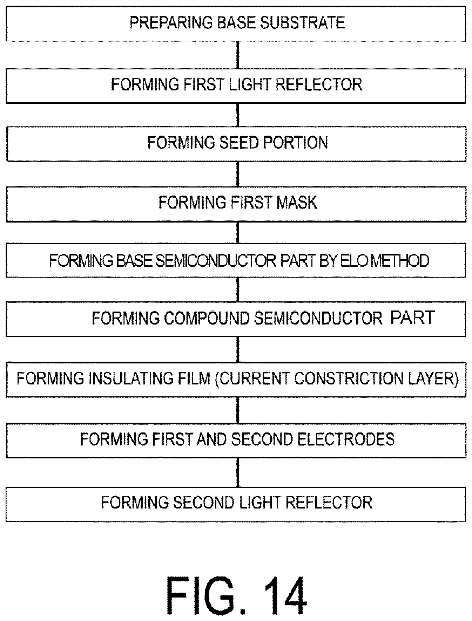

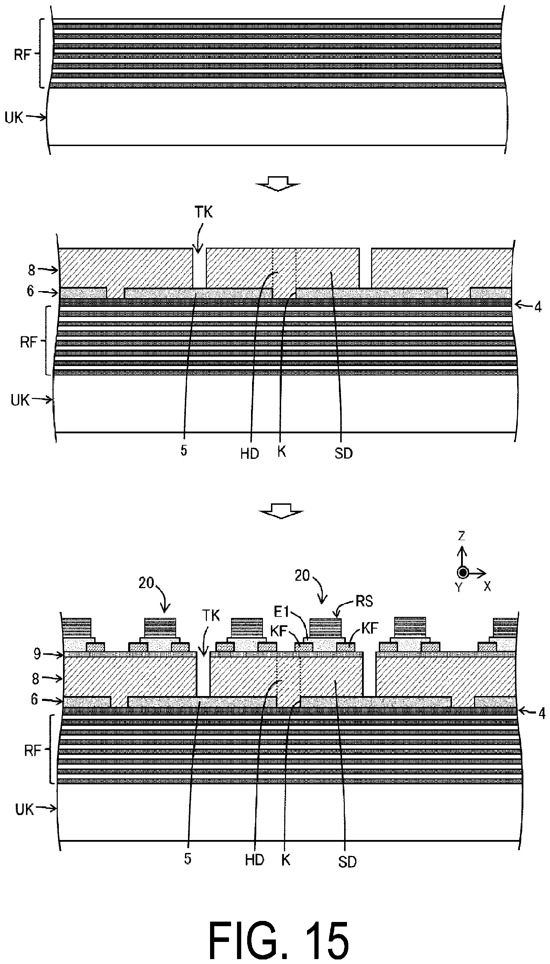

FIG. 14 is a flowchart illustrating an example of a method for manufacturing the semiconductor device according to Example 1. FIG. 15 is a cross-sectional view illustrating an example of the method for manufacturing the semiconductor device according to Example 1. As illustrated in FIGs. 14 and 15, the method for manufacturing the semiconductor device includes preparing the base substrate UK, forming the first light reflector RF, forming the seed portion 4, forming the first mask 6, forming the base semiconductor part 8 by the ELO method, forming the compound semiconductor part 9, forming the insulating film KF (current constriction layer), forming the first and second electrodes E1, E2, and forming the second light reflector RS.

### Base Substrate

A different substrate having a lattice constant different from that of the base semiconductor part including, for example, the GaN-based semiconductor can be used for the main substrate 1 of the base substrate UK. Examples of the different substrate include a single-crystal silicon (Si) substrate, a sapphire (Al₂O₃) substrate, a silicon carbide (SiC) substrate, and an aluminum nitride (AlN) substrate. The plane orientation of the main substrate 1 is, for example, the (111) plane of the silicon substrate, the (0001) plane of the sapphire substrate, or the 6H-SiC (0001) plane of the SiC substrate.

The main substrate 1 may have a thermal conductivity higher than that of the GaN bulk substrate. A SiC substrate may be adopted as the main substrate 1 from the viewpoint of having a better thermal conductivity than the GaN substrate and having translucency. A GaN substrate (bulk crystal) can also be used as the main substrate 1 (see FIG. 10).

In the base substrate UK, for example, as illustrated in FIG. 10, the base portion (base layer) 3 may be provided on the main substrate 1, or the buffer portion 2 (buffer layer) and the base portion 3 may be provided on the main substrate 1. In order to suppress a phenomenon in which the silicon substrate and the GaN-based semiconductor melt together at a high temperature, the base portion 3 or the buffer portion 2 including an AlN layer may be provided when the silicon substrate is used. The AlN layer can be formed using, for example, the MOCVD apparatus, to achieve a thickness of from about 10 nm to about 5 µm. When the silicon substrate is used, the base portion 3 or the buffer portion 2 including the SiC layer may be provided from the viewpoint of excellent thermal conductivity.

The buffer portion 2 need not be provided when the main substrate 1 and the base portion 3 do not melt together. In Example 1, the main substrate 1 is the SiC substrate, and the GaN layer is formed on the main substrate 1 as the base portion 3 by the MOCVD method to achieve a thickness of 1.0 µm.

The buffer portion 2 (for example, aluminum nitride) and/or the base portion 3 (for example, the GaN-based semiconductor) can be formed using a sputtering device (pulse sputter deposition (PSD), pulse laser deposition (PLD), etc.). Film formation using the sputtering device can streamline the manufacturing process.

When the base semiconductor part 8 is grown in the lateral direction using the ELO method, even if the base layer having poor crystallinity is used, its low crystallinity is taken over onto the opening portion K (the first portion HD) and is not taken over onto the second portion SD overlapping the aperture portion AP and the light emitting region of the active layer 9K in plan view (therefore, the second portion SD is a low-defect portion). This reduces the cost while maintaining the light-emitting characteristic.

The base portion 3 may have at least one of the effect of suppressing melting of the main substrate 1 and the first light reflector RF, the effect of improving the crystallinity of the first light reflector RF, the effect of relaxing the internal stress of the base semiconductor part 8 (relaxing warpage of the semiconductor device 30), and the effect of increasing the heat dissipation. The buffer portion 2 may have at least one of the effect of suppressing melting of the main substrate 1 and the base portion 3, the effect of improving the crystallinity of the base portion 3, the effect of relaxing the internal stress of the base semiconductor part 8, and the effect of increasing heat dissipation.

A GaN substrate (bulk crystal) may be used as the main substrate 1. In this case, the first light reflector RF (epitaxial DBR) may be formed (directly) on the main substrate 1, or the first light reflector RF (epitaxial DBR) may be formed on the main substrate 1 via the base portion 3 (for example, a GaN layer). The use of the GaN substrate as the main substrate 1 reduces the number of threading dislocations in the first light reflector RF, and reduces the number of threading dislocations on the opening portion K in the base semiconductor part 8.

Alternatively, the base substrate in which the (11-22) plane of the GaN-based semiconductor layer is formed on the sapphire substrate or the base substrate in which the (20-21) plane of the GaN-based semiconductor layer is formed on a sapphire substrate may be used. Since the semiconductor layer formed epitaxially on these semipolar planes of the base substrate has a high crystallinity, these base substrates can also be used in Example 1.

### First Light Reflector

As illustrated in FIG. 9, the epitaxial DBR having a high reflectance (96% or more) and a high thermal conductivity can be formed by stacking 20 to 40 pairs, each pair including AlN in the first refractive portion R1 and GaN in the second refractive portion R2. In this case, the threading dislocations may be generated by the lattice mismatch or the like in the main substrate 1, the first refractive portion R1, and the second refractive portion R2. However, the first mask 6 stops the threading dislocations (defects extending in the Z-direction) in the first light reflector RF, and does not take them over to the second portion SD of the base semiconductor part 8 and the compound semiconductor part 9 located above (especially the portion overlapping the aperture portion AP). This increases the degree of freedom of design of the base substrate UK and the first light reflector RF, and can provide a design which takes into consideration the heat dissipation, crystal quality, power consumption, manufacturing cost, and the like.

The first light reflector RF made of the epitaxial DBR of AlN (first refractive portion)/GaN (second refractive portion) can increase the thermal conductivity of the first light reflector RF. The first mask 6 can suppress propagation of the stress from the first light reflector RF to the base semiconductor part 8 and the compound semiconductor part 9. The first light reflector RF can, of course, be the epitaxial DBR having a matching lattice system such as AlInN (first refractive portion)/GaN (second refractive portion).

The epitaxial DBR may be formed using the MOCVD method, or the remote plasma chemical vapor deposition (RPCVD) method, which allows low-temperature deposition, or the pulse sputter deposition (PSD) method. The low-temperature film formation method such as the RPCVD method or the PSD method can reduce the temperature difference between during and after the film formation and suppresses generation of cracks due to a difference in thermal expansion coefficient between the main substrate 1 and the epitaxial DBR. Alternatively, the epitaxial DBR may be formed using sputtering or the like capable of low-temperature film formation, and the seed portion 4 may be formed using the MOCVD method.

In Example 1, by using the metal organic vapor phase epitaxial (MOVPE) method, an undoped GaN layer of about 2 µm was deposited on a 6H-SiC (0001) substrate as the base portion 3, and 30 pairs of AlN (first refractive portion)/GaN (second refractive portion) were stacked on the base portion 3 at a growth temperature of 1040°C and a growth pressure of 50 Torr, thus providing the epitaxial DBR. The design peak wavelength of the DBR was 400 nm, and the optical film thickness of AlN in one pair was λ/4. Thus, the first light reflector RF having a high light reflectance of about 98% was obtained.

As illustrated in FIG. 9, the uppermost portion of the first light reflector RF may be the first refractive portion (AlN), on which the seed portion 4 including the GaN-based semiconductor may be provided. Alternatively, as illustrated in FIG. 11, the uppermost portion of the first light reflector RF may be the second refractive portion (GaN). The layer in contact with the lower surface of the first mask 6 is the GaN-based semiconductor layer. This decreases the likelihood of occurrence of a phenomenon in which the semiconductor layer in contact with the lower surface of the first mask 6 is re-evaporated due to a temperature rise during growth of the base semiconductor part 8 after formation of the first mask 6.

The refractive material of the first refractive portion R1 may be AlN, AlInN, or InN. The refractive material (for example, AlN) of the first refractive portion R1 may have a thermal conductivity larger than that of the GaN-based semiconductor (for example, GaN) of the second refractive portion R2. The refractive material of the first refractive portion R1 may have a lattice parameter different from that of the GaN-based semiconductor of the second refractive portion R2. The refractive material (for example, AlN) of the first refractive portion R1 may have a smaller lattice constant than the GaN-based semiconductor (for example, GaN) of the second refractive portion R2. The thermal expansion coefficient of the main material of the main substrate 1 (for example, SiC, Si) < the thermal expansion coefficient of the GaN-based semiconductor of the second refractive portion R2 (for example, GaN) < the thermal expansion coefficient of the refractive material of the first refractive portion R1 (for example, AlN).

### First Mask

The opening portion K in the first mask 6 functions as a growth initiation hole to expose the nitride semiconductor that serves as the seed and initiates the growth of the base semiconductor part 8. The mask portion 5 functions as a selective growth mask for lateral growth of the base semiconductor part 8. Examples of the mask portion 5 that can be used include a single-layer film including any one of a silicon oxide film (SiOₓ), a titanium nitride film (TiN or the like), a silicon nitride film (SiNₓ), a silicon oxynitride film (SiON), and a metal film having a high melting point (for example, 1000°C or higher), or a layered film including at least two of these.

For example, a silicon oxide film having a thickness of from about 10 nm to about 500 nm is formed on the entire surface by sputtering, and a resist is applied onto the entire surface of the silicon oxide film. Subsequently, the resist is patterned by photolithography to form the resist with a plurality of stripe-shaped opening portions. Subsequently, a part of the silicon oxide film is removed with a wet etchant such as a hydrofluoric acid (HF) or a buffered hydrofluoric acid (BHF) to form the plurality of opening portions K, and the resist is removed by organic cleaning. Thus, the first mask 6 is formed. Alternatively, the opening portion K may be formed by using a typical lift-off method.

The opening portion K has a longitudinal shape (slit shape) and is periodically arranged in an a-axis direction (X-direction) of the base semiconductor part layer 8. The width (opening width) of the opening portion K can be set to about 0.1 µm to 20µm (for example, about 5 µm). As the width of each opening portion decreases, the number of threading dislocations propagating from each opening portion to the base semiconductor part 8 decreases. The second portion (low-defect portion) SD can be made large. The thickness of the mask portion 5 is preferably thin from the viewpoint of heat dissipation, but may be 10 nm or more, 20 nm or more, or 40 nm or more in consideration of suppression of the mutual reaction between the first mask 6 and the base semiconductor part 8.

The width of the mask portion 5 can be from 10 µm to 200 µm. By increasing the width of the mask portion 5, the area (effective area) of the second portion SD (low-defect portion) of the base semiconductor part 8 can be increased. Accordingly, the aperture diameter (diameter of the aperture portion AP) can also be increased, achieving a high-output semiconductor laser device.

The silicon oxide film may decompose and evaporate in minute amounts during film formation of the base semiconductor part 8 and may be taken into the base semiconductor part 8. However, silicon nitride and silicon oxynitride films have the advantage of being difficult to decompose and evaporate at high temperatures.

Therefore, the first mask 6 may be a single-layer film of a silicon nitride or silicon oxynitride film, a layered film in which a silicon oxide film and a silicon nitride film are formed in this order, a laminate film in which a silicon nitride film and a silicon oxide film are formed in this order, or a layered film in which a silicon nitride film, a silicon oxide film, and a silicon nitride film are formed in this order.

An abnormal portion such as a pinhole in the mask portion 5 may be eliminated by performing organic cleaning or the like after film formation and introducing the film again into a film forming device to form the same type of film. A typical silicon oxide film (single layer) can also be used to form a good quality first mask 6 by such a method to form the film again.

The mask portion 5 may have a light refractive index smaller than that of the second refractive portion R2 (for example, a GaN-based semiconductor). In Example 1, since the first mask 6 exists in the cavity, the first mask 6 can be designed so as not to disturb the resonance of light as much as possible. Since the mask portion 5 is a selective growth film and also a light transmission film, the light transmission characteristic may be increased (light absorption may be reduced). When the uppermost portion of the first light reflector RF (the second refractive portion R2) or the seed portion 4 is a GaN layer and a single layer of silicon oxide film or silicon nitride film having a lower refractive index than GaN is used as the mask material, the optical film thickness (physical film thickness/refractive index) of the silicon oxide film or silicon nitride film can be made to be an integer of λ (oscillation wavelength)/2 times the optical film thickness (physical film thickness/refractive index). This increases the reflectance in the first light reflector RF. Furthermore, a mask material including a plurality of film types, each having an optical film thickness of an integer multiple of λ/2, may be used. For example, when the uppermost portion (the second refractive portion R2) of the first light reflector RF or the seed portion 4 is a GaN layer, a silicon oxide film and a silicon nitride film having a refractive index higher than the silicon oxide film can be formed in this order on top of this GaN layer, both films having an optical film thickness of λ/4. By adopting such a pair of a silicon oxide film having the optical film thickness of /4 and a silicon nitride film having the optical film thickness of /4 as the first mask, the light reflectance can be further increased. Conversely, a design that involves decreasing the reflectance of the first light reflector RF by the first mask 6 is also possible.

### Base semiconductor part

In Example 1, the GaN layer was provided as the base semiconductor part 8 (ELO semiconductor layer), and the ELO film of gallium nitride (GaN) was formed on the template substrate described above using the MOCVD apparatus. The following may be adopted as examples of the ELO film formation conditions: substrate temperature: 1120°C, growth pressure: 50 kPa, trimethylgallium (TMG): 22 sccm, NH₃: 15 slm, and V/III = 6000 (ratio of group V raw material supply amount to group III raw material supply amount).

In this case, the base semiconductor part 8 was selectively grown (vertically grown) on the seed portion 3 (for example, the GaN layer) exposed from the opening portion K, and was subsequently grown laterally on the mask portion 5. The lateral growth was stopped before two base semiconductor parts 8 laterally growing from both sides on the mask portion 5 met.

A single silicon nitride film was used as the mask portion 5, and the optical film thickness of the mask portion 5 was set to λ/4 under the assumption that the emission wavelength was 450 nm. The width of the mask portion 5 was 50 µm, the width of the opening portion K was 5 µm, the width of the gap TK was 3 µm, the lateral width of the base semiconductor part 8 was 52 µm, the width (size in the X-direction) of the low-defect portion was 23.5 µm, and the layer thickness of the base semiconductor part 8 was 5 µm. Thus, the aspect ratio of the base semiconductor part 8 was 52 µm/5 µm = 10.4, achieving a very high aspect ratio. The width (effective width) of the low-defect portion SD may be 10 µm or more or 20 µm or more.

In Example 1, the lateral film formation rate is increased in the formation of the base semiconductor part 8. A method for increasing the lateral film formation rate is as follows. First, a vertical growth layer growing in the Z-direction (c-axis direction) is formed on the seed portion 3 exposed from the opening portion K, followed by a lateral growth layer growing in the X-direction (a-axis direction). In this case, by setting the thickness of the vertical growth layer to 10 µm or less, preferably 5 µm or less, and more preferably 3 µm or less, the thickness of the lateral growth layer may be suppressed to be thin and the lateral film formation rate may be increased.

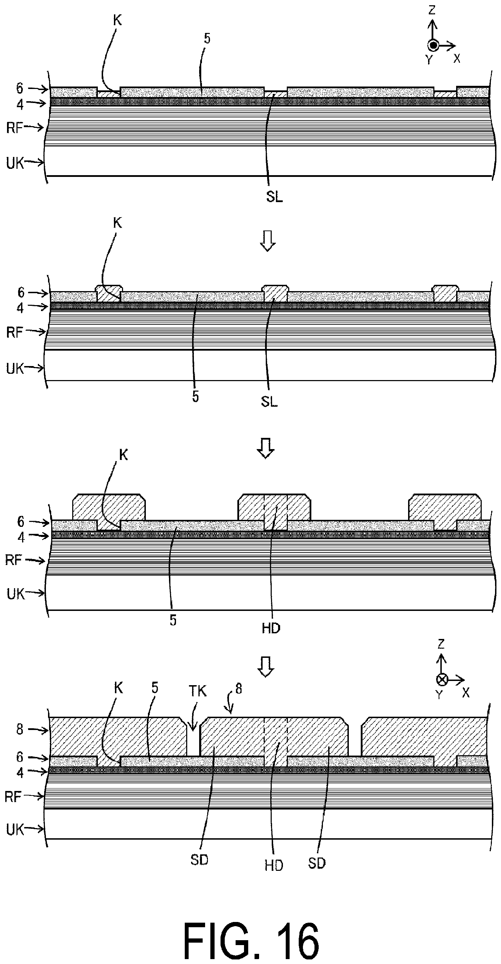

FIG. 16 illustrates cross-sectional views of an example of the lateral growth of the base semiconductor part 8. As illustrated in FIG. 16, an initial growth layer SL is formed on the seed portion 3, and then the base semiconductor part 8 is grown laterally from the initial growth layer SL. The initial growth layer SL serves as a start point of the lateral growth of the base semiconductor part 8. By appropriately controlling the ELO film formation conditions, the base semiconductor part 8 can be controlled to grow in the Z-direction (c-axis direction) or in the X-direction (a-axis direction).

Here, the film formation of the initial growth layer SL may be stopped just before the edge of the initial growth layer SL rides up to the upper surface of the mask portion 5 (when it is in contact with the top edge of the side surface of the mask portion 5) or just after it rides up to the upper surface of the mask portion 5 (that is, the ELO film formation conditions may be switched from the film formation conditions in the c-axis direction to the film formation conditions in the a-axis direction at this timing). In this way, the initial growth layer SL protrudes slightly from the mask portion 5 before lateral film formation is performed, reducing the amount of material consumed for growth in the thickness direction of the base semiconductor part 8 and allowing the base semiconductor part 8 to be grown laterally at high speed. The initial growth layer SL may be formed to have a thickness of, for example, 2.0 µm or more and 3.0 µm or less.

The film-forming temperature of the base semiconductor part 8 (ELO semiconductor portion) may exceed 1200°C or may be equal to or less than 1150°C. The ELO semiconductor portion can be formed even at a low temperature below 1000°C, which is more preferable from the viewpoint of reducing the interaction. It has been found that, in such low-temperature film formation, when trimethyl gallium (TMG) is used as a gallium raw material, the raw material is not sufficiently decomposed, and gallium atoms and carbon atoms are simultaneously taken into the ELO semiconductor portion in larger quantities than usual. This may be because the ELO method is faster for the film formation in the a-axis direction and slower for the film formation in the c-axis direction, thus taking up more during the c-plane film formation.

It has also been found that carbon incorporated into the ELO semiconductor portion reduces the reaction with the mask portion 5 and adhesion between the mask portion 5 and the ELO semiconductor portion (base semiconductor part 8). Therefore, in the low-temperature film formation of the ELO semiconductor portion, the amount of ammonia supplied is reduced and the film is formed at about low V/III (<1000) to incorporate carbon elements in the raw material or chamber atmosphere into the ELO semiconductor portion and reduce the reaction with the mask portion 5. In this case, the base semiconductor part 8 includes carbon.

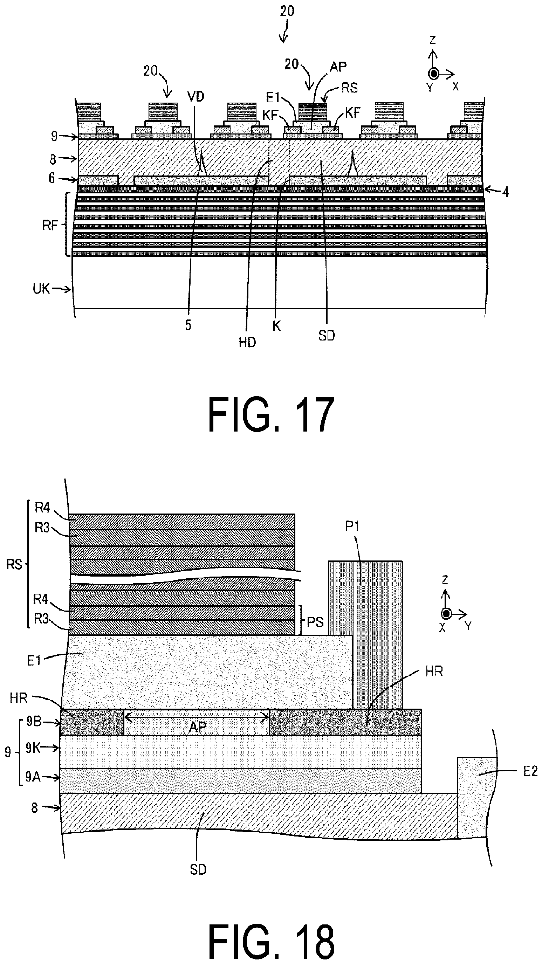

FIG. 17 is a plan view illustrating another configuration of the semiconductor device of Example 1. In FIG. 16, two base semiconductor parts 8, which grow laterally from both sides of the mask portion 5, are stopped from growing laterally before they meet each other, but the configuration is not limited thereto. As illustrated in FIG. 17, the lateral growth may be stopped after two base semiconductor parts 8, which grow laterally from both sides of the mask portion 5, meet each other. In this case, since the base semiconductor part 8 includes a void VD overlapping the center of the mask portion 5 in plan view and the number of dislocations (crystal defects) in the meeting portion increases, the aperture portion AP of the semiconductor laser element 20 is configured not to overlap the meeting portion in plan view.

### Compound semiconductor part

The base semiconductor part 8 and the compound semiconductor part 9 may be formed successively with the same device (for example, the MOCVD apparatus). Alternatively, the substrate may be taken out of the device after the base semiconductor part 8 is formed, and the compound semiconductor part 9 is formed after treating the surface of the base semiconductor part 8 by, for example, polishing. In this case, the compound semiconductor part 9 may be formed after the n-type GaN-based semiconductor layer (for example, having a thickness of about 0.1 µm to about 3 µm) serving as a buffer during regrowth is formed on the base semiconductor part 8. In addition to the MOCVD apparatus, a sputtering apparatus, a remote plasma CVD (RPCVD) apparatus, a pulse sputter deposition (PSD) apparatus, and the like can be used to form the compound semiconductor part 9. Because the remote plasma CVD apparatus and the PSD apparatus do not use hydrogen as a carrier gas, the low-resistance p-type GaN-based semiconductor portion can be formed.

The MQW structure of the active layer 9K may be, for example, a five to six period structure of InGaN/GaN. The composition of In varies with the desired emission wavelength, with an In concentration of about 15 to 20% for blue (around 450 nm) and about 30% for green (around 530 nm). If necessary, an electron blocking layer (for example, an AlGaN layer) may be formed on the active layer 9K. To reduce the resistance, a surface (about 10 nm) of the p-type semiconductor layer 9B may be a p-type highly doped layer.

FIG. 18 is a cross-sectional view illustrating another configuration of the semiconductor device of Example 1. Although the aperture portion AP is formed in the insulating film KF in FIG. 8, the configuration is not limited thereto. As illustrated in FIG. 18, the configuration (in which the high resistance portion HR surrounds the aperture portion AP) may be obtained by providing an annular high-resistance portion HR (region with a low p-type doping concentration) in the p-type semiconductor layer 9B, and using the inner side of the high-resistance portion HR as the aperture portion AP (current constriction portion). The aperture portion AP can also be formed by implanting aluminum (Al) or iron (Fe). In order to obtain the effect of confining light due to the refractive index difference in the aperture portion AP, the periphery of the aperture can be dug in to generate a difference in the refractive index between the aperture portion AP and its periphery (for example, the refractive index of the periphery is made smaller than that of the aperture portion AP).

### First and Second Electrodes

The first electrode E1 is made of a transparent conductive material having light permeability. Examples of the transparent conductive material include indium tin oxide (including crystalline ITO, amorphous ITO, and Sn-doped In₂O₃), indium zinc oxide (IZO), F-doped In₂O₃ (IFO), tin oxide (including SnO₂, Sb-doped SnO₂, and F-doped SnO₂), and zinc oxide (including ZnO, AI-doped ZnO, and B-doped ZnO).

The first electrode E1 may include at least one of gallium (Ga) oxide, titanium (Ti) oxide, niobium (Nb) oxide, and nickel (Ni) oxide as a base layer. The aperture diameter of the first electrode E1 (the diameter of the current injection region in contact with the p-type semiconductor portion) can be, for example, from 2 µm to 100 µm.

The first pad P1 in contact with the first electrode E1 may have a single-layer structure or a multi-layer structure including at least one of Au, Ag, Pd, Pt, Ni, Ti, V, W, Cr, Al, Cu, Zn, Sn, and In. As the multi-layer structure, for example, assuming that the left side indicates the lower layer side, a configuration such as Ti layer/Au layer, Ti layer/Al layer, Ti layer/Al layer/Au layer, Ti layer/Pt layer/Au layer, Ni layer/Au layer, Ni layer/Au layer/Pt layer, Ni layer/Pt layer, Pd layer/Pt layer, or Ag layer/Pd layer can be employed.

### Second Light Reflector

As illustrated in FIG. 8, for example, the second light reflector RS is a DBR in which the third refractive portion R3 and the fourth refractive portion R4 are alternately stacked. The third refractive portion R3 includes, for example, SiO₂. The fourth refractive portion R4 is a layer including a material having a refractive index higher than that of the third refractive portion R3, and includes, for example, Ta₂O₅, HfO₂, ZrO₂, TiO₂, Al₂O₃, Nb₂O₅, ZnO, AlN, SiN, or MgO. At an interface between the third refractive portion R3 and the fourth refractive portion R4, the light that is incident on the interface at an angle equal to or larger than a critical angle is totally reflected at the interface, achieving a high light reflectance (for example, 96% or more) in the second light reflector RS.

In FIG. 5, when the main substrate 1 is translucent, with respect to the emission wavelength from the active layer 9K, the second light reflector RS may have a reflectance of substantially 100%, for example, about 99%, and the first light reflector RF may have a reflectance of, for example, about 98% which is lower than that of the second light reflector RS. In this case, the light reciprocating between the first light reflector RF and the second light reflector RS is emitted as laser light from the lower surface of the first light reflector RF (at a portion overlapping the aperture portion AP in plan view). The configuration is not limited to one in which the laser light is emitted from the first light reflector RF side. When the main substrate 1 is not translucent, the laser light may be emitted from the second light reflector RS side, or from each of the first and second light reflectors RF, RS.

### Division

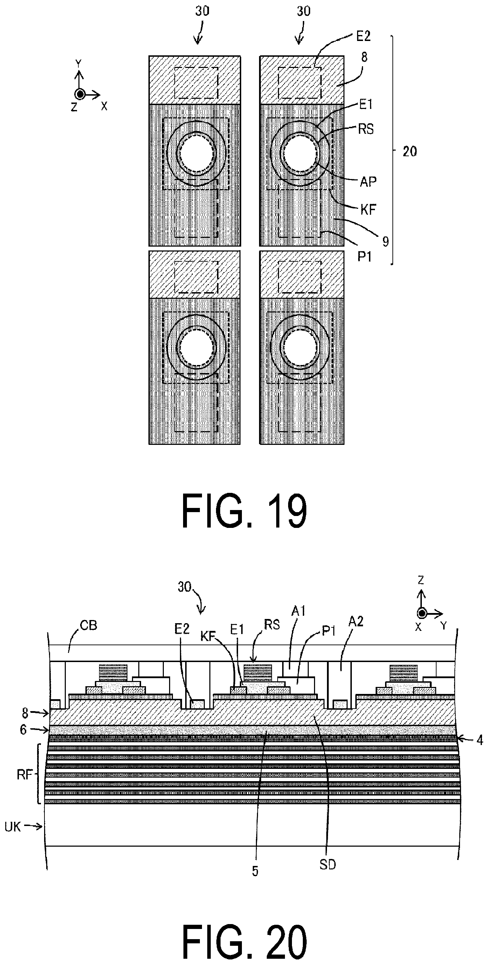

FIG. 19 is a plan view illustrating another configuration of the semiconductor device of Example 1. As illustrated in FIG. 19, the semiconductor device 30 in FIG. 7 may be divided into a plurality of semiconductor devices 30, each including one semiconductor laser element 20.

### Variation

FIG. 20 is a cross-sectional view illustrating another configuration of the semiconductor device according to Example 1. As illustrated in FIG. 20, the semiconductor device 30 includes the circuit board CB disposed on the opposite side of the main substrate 1 and is electrically connected to the first and second electrodes E1, E2. Specifically, the first electrode E1 is connected to the circuit board via the first pad P1 and a conductive adhesive A1, and the second electrode E2 is connected to the circuit board CB via a conductive adhesive A2. The circuit board CB may be configured to drive the semiconductor laser elements 20.

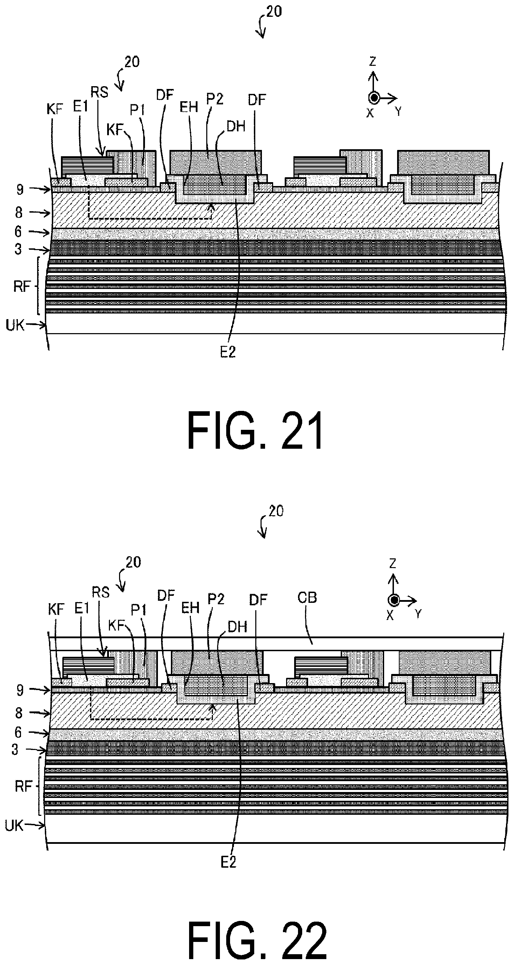

FIGs. 21 and 22 are cross-sectional views each illustrating another configuration of the semiconductor device according to Example 1. The semiconductor device 30 illustrated in FIG. 21 includes the first pad P1 in contact with the first electrode E1 and the second pad P2 in contact with the second electrode E2. The upper surface levels (height positions) of the first and second pads P1 and P2 coincide with each other, and the upper surfaces of the first and second pads P1 and P2 are located higher than the upper surface of the second light reflector RS. This facilitates mounting on the circuit board CB (see FIG. 22). An insulating film DF may be provided between the peripheral portion of the second electrode E2 and the base semiconductor part 8. The insulating film DF can suppress a short circuit between the second electrode E2 and the upper surface of the compound semiconductor part 9 (p-type semiconductor layer), and reduce the likelihood of movement of holes, which are injected from the first electrode E1 into the p-type semiconductor layer, to the second electrode E2 without passing through the active layer. Alternatively, the second electrode E2 may be configured such that its non-peripheral portion EH is recessed from the peripheral portion, and the recessed non-peripheral portion EH is filled with an insulating body DL. The insulating body DL planarizes the upper surface of the second pad P2. In addition, the first pad P1 which is brought into contact with the upper surface of the second light reflector RS can increase the heat dissipation.

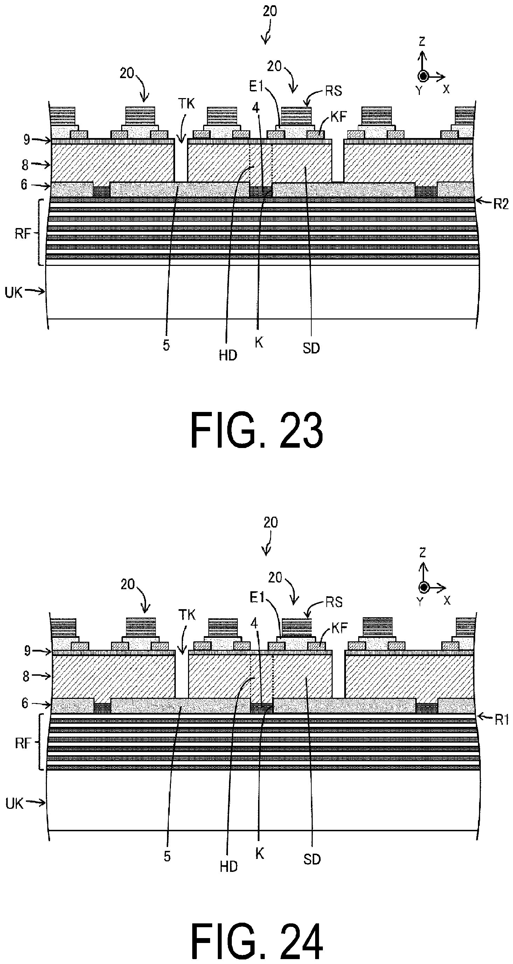

FIGs. 23 and 24 are cross-sectional views each illustrating another configuration of the semiconductor device according to Example 1. In FIG. 5 and the like, the seed portion 4 is formed over the entire surface of the first light reflector RF, but the configuration is not limited thereto. As illustrated in FIGs. 23 and 24, the seed portion 4 may be locally provided so as to overlap the opening portion K of the first mask 6. In FIG. 23, the uppermost portion of the first light reflector RF is provided as the second refractive portion R2. In FIG. 24, the uppermost portion of the first light reflector RF is provided as the first refractive portion R1. In this way, the stress from the seed portion 4 can be reduced. The seed portion 4 may be formed at a low temperature of 800°C or less.

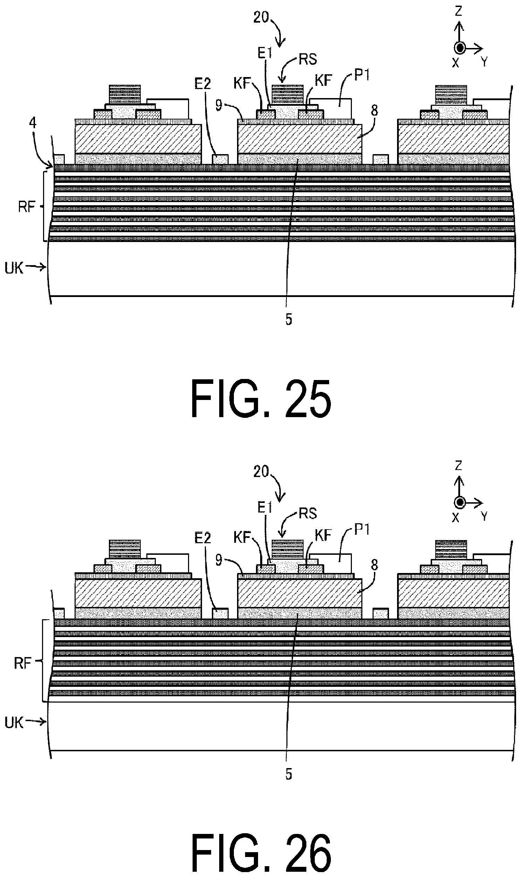

FIGs. 25 and 26 are cross-sectional views each illustrating another configuration of the semiconductor device according to Example 1. Although the second electrode E2 is in contact with the base semiconductor part 8 in FIG. 6, the configuration is not limited thereto. As illustrated in FIG. 25, the second electrode E2 may be in contact with the seed portion 4. In this case, the seed portion 4 may be, for example, the n-type GaN-based semiconductor layer. As illustrated in FIG. 26, the second electrode E2 may be in contact with the uppermost portion (for example, the second refractive portion R2) of the first light reflector RF. In this case, the uppermost portion of the first light reflector RF can be, for example, the n-type GaN-based semiconductor layer.

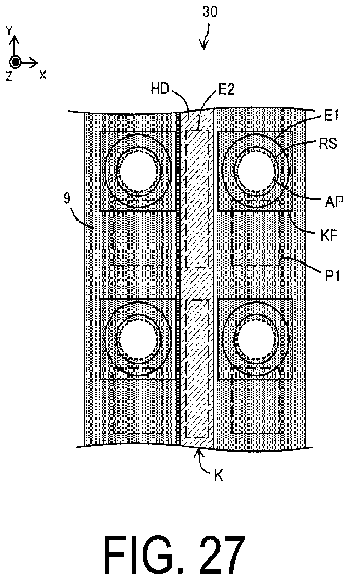

FIG. 27 is a plan view illustrating another configuration of the semiconductor device according to Example 1. As illustrated in FIG. 27, the first and second electrodes E1, E2 may be arranged in the X-direction, and the second electrode E2 may overlap the first portion HD in plan view. The first electrode E1 and the aperture portion AP overlap the second portion SD in plan view.

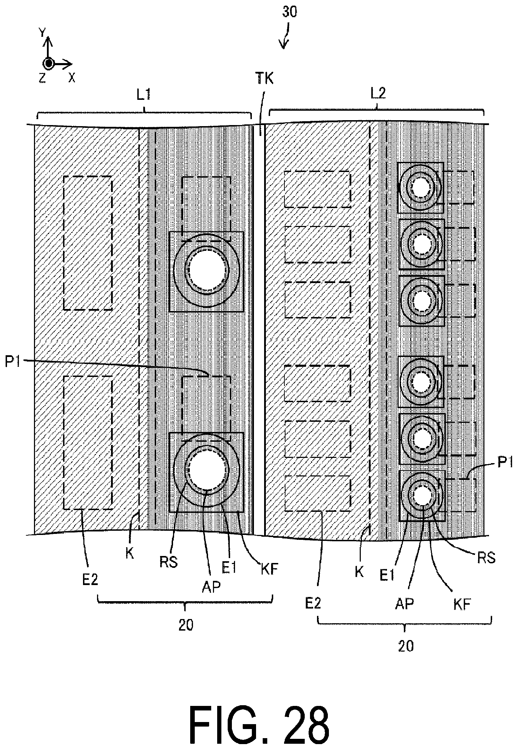

FIG. 28 is a plan view illustrating another configuration of the semiconductor device according to Example 1. The semiconductor device 30 illustrated in FIG. 28 includes a first region L1 and a second region L2 having the same area and located adjacent to each other in the X-direction across the gap TK interposed therebetween. The shape of the semiconductor laser elements 20 differs between the two regions L1, L2.

Specifically, a plurality of two semiconductor laser elements 20 are arranged in the Y-direction in the first region L1, and a plurality of six semiconductor laser elements 20 are arranged in the Y-direction in the second region L2. The aperture diameter of the semiconductor laser element 20 in the first region L1 is larger than the aperture diameter of the semiconductor laser element 20 in the second region L2.

In the semiconductor laser elements 20 of the first region L1, in plan view, the aperture portion AP and the first pad P1 are arranged in the Y-direction and, with the Y-direction as the longitudinal direction, the second electrode E2, which is in contact with the base semiconductor part 8, and the first pad P1 are arranged in the X-direction. In the semiconductor laser elements 20 of the second region L2, in plan view, the aperture portion AP and the first pad P1 are arranged in the X-direction and, with the X-direction as the longitudinal direction, the aperture portion AP is located between the second electrode E2, which is in contact with the base semiconductor part 8, and the first pad P1 in the X-direction.

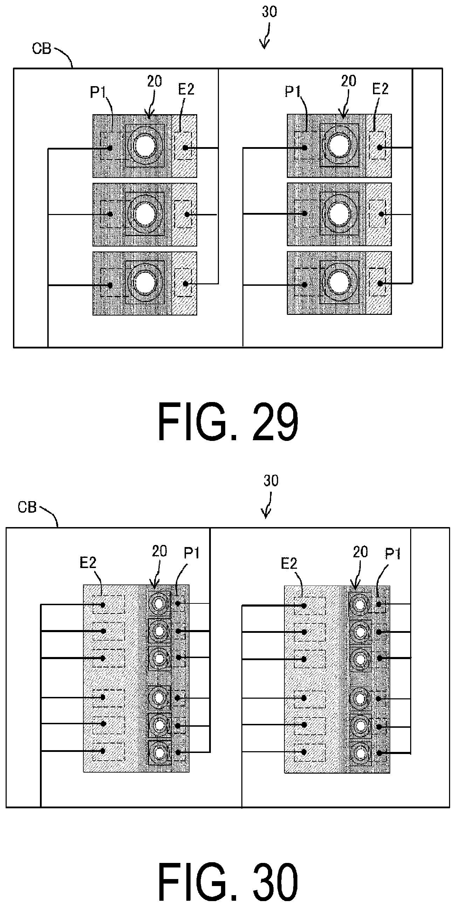

FIGs. 29 and 30 are schematic plan views each illustrating another configuration of the semiconductor device according to Example 1. The semiconductor device 30 in FIG. 29 is obtained by mounting the plurality of semiconductor devices illustrated in FIG. 19 on the circuit board CB. The semiconductor device 30 in FIG. 30 is obtained by dividing the region of the semiconductor device 30 in FIG. 28 and mounting the plurality of semiconductor devices obtained from the second region L2 on the circuit board CB.

### Example 2

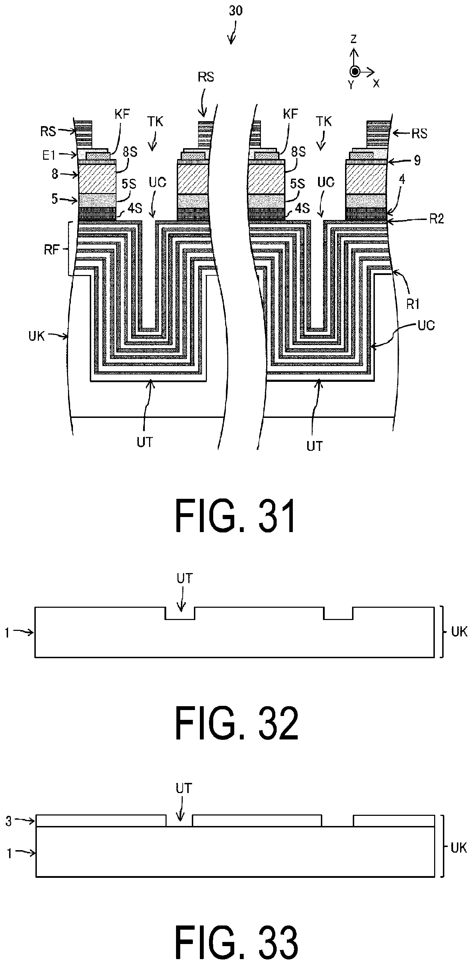

FIG. 31 is a cross-sectional view illustrating a configuration of the semiconductor device according to Example 2. The semiconductor device 30 according to Example 2 includes, for example, the base substrate UK illustrated in FIG. 10, the first light reflector RF is located on the base substrate UK, and the base substrate UK has a recessed portion UT with its upper surface open.

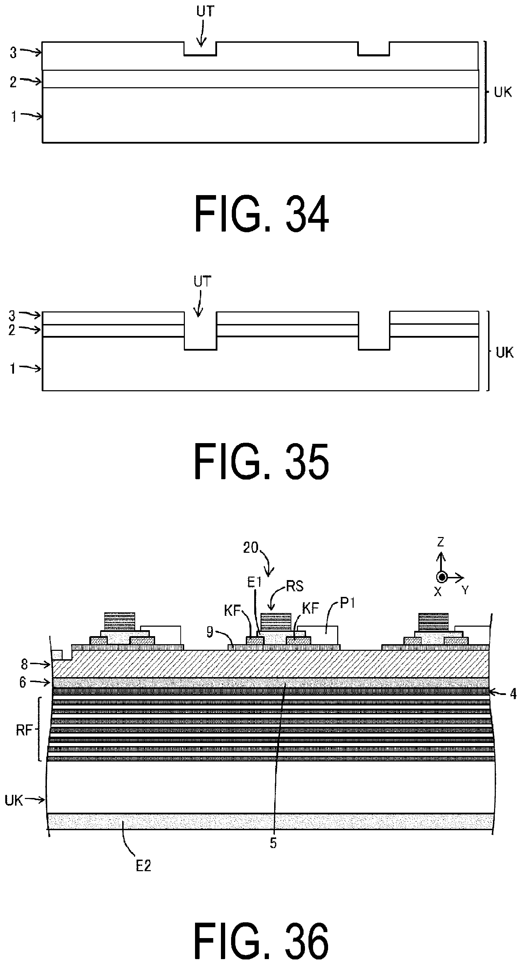

FIGs. 32 and 35 are cross-sectional views each illustrating a configuration of the base substrate according to Example 2. In Example 2, as illustrated in FIG. 32, a portion of the main substrate 1 may be recessed at portions corresponding to the recessed portion UT. As illustrated in FIG. 33, the base substrate UK may include the base portion 3 located above the main substrate 1, and the base portion 3 may be penetrated at portions corresponding to the recessed portion UT. As illustrated in FIG. 34, the base substrate UK may include the buffer portion 2 and the base portion 3 located above the main substrate 1, and the base portion 3 may be recessed at portions corresponding to the recessed portion UT. As illustrated in FIG. 35, the base substrate UK may include the buffer portion 2 and the base portion 3 located above the main substrate 1, the main substrate 1 may be recessed at portions corresponding to the recessed portion UT, and the buffer portion 2 and the base portion 3 may be penetrated at portions corresponding to the recessed portion UT. The recessed portion UT is formed in a stripe shape extending in the Y-direction, the width (size in the X-direction) of the recessed portion UT is, for example, 3 µm, and the depth (size in the Z-direction) of the recessed portion UT is, for example, 5 µm.

In FIG. 31, the second light reflector RS does not overlap the recessed portion UT in plan view. The first and second refractive portions R1, R2 of the first light reflector RF constitute a U-shaped portion UC along the recessed portion UT, the U-shaped portion UC overlapping the center of the mask portion 5 in plan view. The semiconductor device 30 of Example 2 includes the gap TK in contact with the side surfaces of the compound semiconductor part 9 and the base semiconductor part 8, the gap TK overlapping the recessed portion UT in plan view.

The gap TK is in contact with a side surface 5S of the mask portion 5 and a side surface 4S of the seed portion 4, and the U-shaped portion UC (of the second refractive portion R2) located at the uppermost portion of the first light reflector RF is in contact with the gap TK. Alternatively, the U-shaped portion UC located at the uppermost portion of the first light reflector RF (of the first refractive portion R1) may be in contact with the gap TK. The recessed portion UT provided in the base substrate UK and the U-shaped portion provided in the first light reflector RF, which is the epitaxial DBR, relax the stress of the first light reflector RF and reduce the generation of cracks. This also increases the heat dissipation from the first light reflector RF.

### Example 3

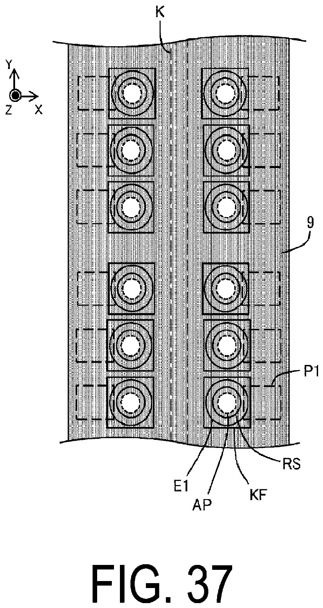

FIG. 36 is a cross-sectional view illustrating a configuration of the semiconductor device according to Example 3. FIG. 37 is a cross-sectional view illustrating a configuration of the semiconductor device according to Example 3. In the semiconductor device in FIGs. 36 and 37, the second electrode E2 is provided on the back surface of the base substrate UK. As the base substrate UK, for example, an n-type doped main substrate 1 (for example, a SiC substrate or a Si substrate) can be used. When the base portion 3 is provided on the base substrate UK, the base portion 3 is made of the n-type semiconductor layer (for example, a GaN-based semiconductor). When the buffer portion 2 and the base portion 3 are provided on the base substrate UK, these are made of n-type semiconductor layers (for example, a nitride semiconductor). Each epitaxial layer (for example, a nitride semiconductor) and the seed portion 4 (for example, a GaN-based semiconductor) of the first light reflector RF are also n-type semiconductor layers.

### Example 4

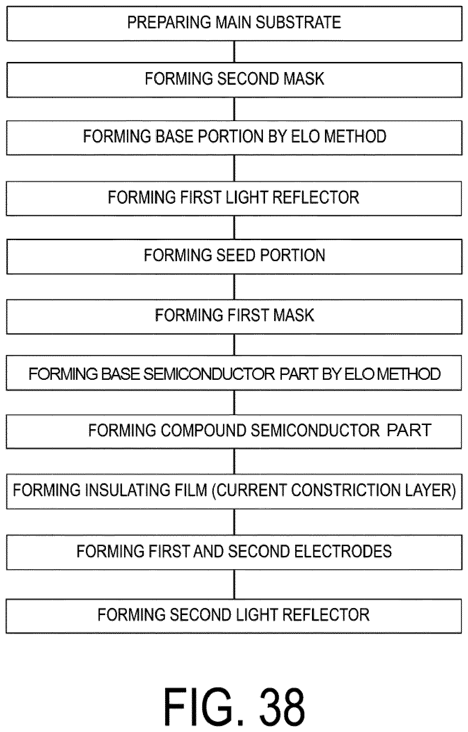

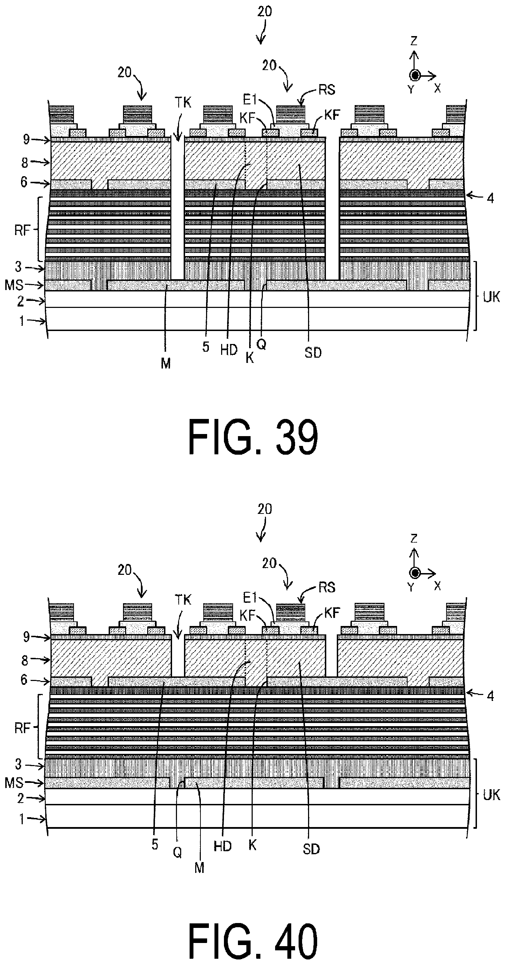

FIG. 38 is a flowchart illustrating an example of a manufacturing method for manufacturing a semiconductor device according to Example 4. FIGs. 39 and 40 are cross-sectional views each illustrating a configuration of the semiconductor device according to Example 4. In Example 4, the base substrate UK includes the main substrate 1 and a second mask MS located above the main substrate 1. In FIG. 38, after preparing the main substrate 1, the second mask MS is formed and the base portion 3 is formed by the ELO method. That is, the semiconductor device 30 in FIGs. 39 and 40 includes the base portion 3 formed by the ELO method. The buffer portion 2 may be provided between the main substrate 1 and the second mask MS.

In FIGs. 39 and 40, for example, the main substrate 1 may be the SiC substrate, the buffer portion 2 may be the GaN-based semiconductor layer, the second mask MS may be a single-layer film or a multi-layer film including the silicon oxide film and/or the silicon nitride film, and the base portion 3 may be the GaN-based semiconductor layer formed by the ELO method.

The second mask MS includes a mask portion M and an opening portion Q. In FIG. 39, the opening portion K of the first mask 6 and the opening portion Q of the second mask MS overlap in plan view. As illustrated in FIG. 40, the gap TK of the base semiconductor part 8 and the opening portion Q of the second mask MS may overlap in plan view.

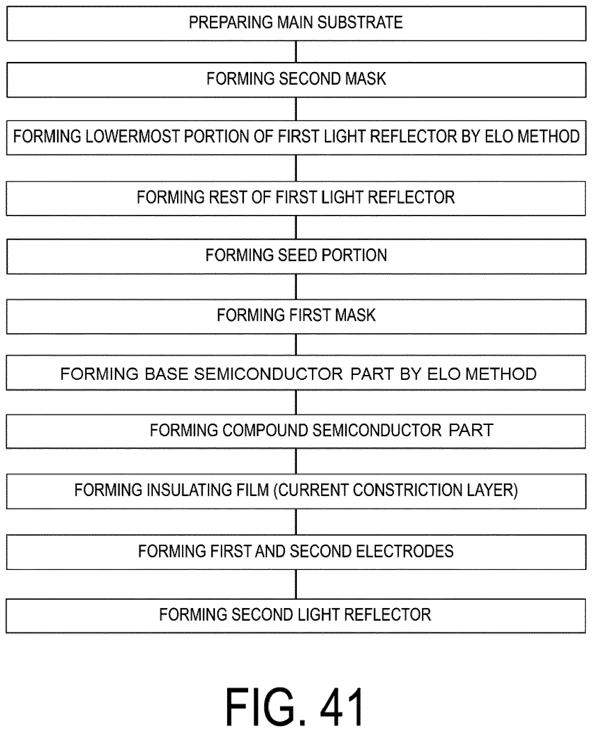

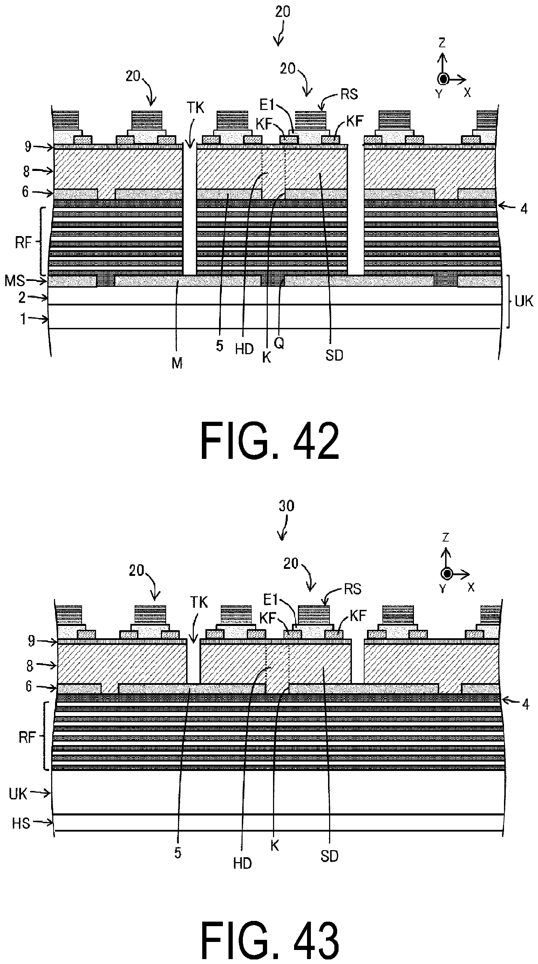

FIG. 41 is a flowchart illustrating another example of a method for manufacturing the semiconductor device according to Example 4. FIG. 42 is a cross-sectional view illustrating another configuration of the semiconductor device according to Example 4. In FIG. 41, after preparing the main substrate 1, the second mask MS is formed and the lowermost portion of the first light reflector RF is formed by the ELO method. For this reason, the semiconductor device 30 of FIG. 42 includes the first light reflector RF in which the lowermost portion thereof is formed by the ELO method.

In Example 4, the base portion 3 or the lowermost portion of the first light reflector RF (epitaxial DBR) is formed by the ELO method, thus reducing the dislocations (defects) of the first light reflector RF and increasing the light reflectance.

### Example 5

In Example 5, the epitaxial DBR of InAlN (first refractive portion R1)/GaN (second refractive portion R2) was formed. In this case, the base substrate UK was placed in the reactor of the MOCVD apparatus, H₂ and NH₃ were supplied into the reactor to raise the substrate temperature to 1070°C, and TMG was supplied to the base substrate UK to grow 100 nm of the GaN layer as the buffer portion 2. Next, after the substrate temperature was lowered to 930°C (first temperature), the supplied gas was switched from H₂ to N₂, and TMI and TMA were supplied to grow 50 nm of the non-doped InAlN layer (first refractive portion R1). Next, by supplying TEG and SiH₄ in a state where the substrate temperature was maintained at 930°C, 5 nm of the Si-doped GaN layer was formed as the first layer of the second refractive portion R2. Subsequently, the supplied gas was switched from N₂ to H₂, the substrate temperature was raised to 1070°C (second temperature), and TMG was supplied to grow 40 nm of the non-doped GaN layer as the second layer of the second refractive portion R2. Thereafter, the above process was repeated to form the epitaxial DBR composed of 40 pairs of InAlN/ GaN. When the first light reflector RF made of InAlN/GaN and its lattice matched with the base semiconductor part 8 (for example, the GaN layer) was formed, the GaN substrate (bulk crystal) could be used as the base substrate UK. In this case, the threading dislocation density on the opening portion K of the first mask 6 could be suppressed to about 5 x 10⁶ cm⁻² or less, and the aperture portion AP could be formed also on the opening portion K.

### Example 6

In Example 6, the first light reflector RF (epitaxial DBR) is formed by the PSD method. In the PSD method, all or a part of elements for forming the compound epitaxial layer are intermittently supplied. All of the constituent elements need to be supplied to form the compound epitaxial layer, but in some cases, only some of the elements may be supplied intermittently. That is, all or some of the raw materials of the constituent elements are intermittently excited. Typically, in the case of a nitride of Group III-V, all of the Group III elements can be intermittently supplied, but to form a mixed crystal, some of the Group III elements may be intermittently supplied and the other Group III elements may be continuously supplied (preferably at a low supply rate).

In the case of the Group V elements, when nitrogen is supplied in the form of a gas to be present in the vicinity of the substrate growth surface in the form of gas (molecules, radicals, or ions), there is no need to intentionally supply nitrogen intermittently. The element N can also be intermittently supplied by, for example, intermittently exciting (sputtering) a raw material containing N, for example, a nitride of the Group III-V. The Group V element may be supplied by intermittently exciting the raw material, by allowing the Group V element raw material to be present in the atmosphere, or by allowing another raw material to be intermittently excited while allowing the Group V element raw material to be present in the atmosphere. When the plurality of elements are intermittently supplied, the timings at the plurality of elements are supplied may or may not be the same.

As for the supply duration, if it is too short, a large amount of energy is given instantaneously to increase the supply rate during the supply period in order to obtain a practical film forming rate, and as a result, droplets are likely to occur as in the PLD method. On the other hand, if the supply duration is too long, it may not be possible to obtain a supply stop time for allowing sufficient migration. As for the supply stop time (s), if it is too short, it is difficult to obtain good crystals due to insufficient time for migration, and if it is too long, impurities may be easily taken or cause a difficulty in continuing the film formation process depending on the film formation method.

In Example 6, 1.0 sccm of Ar gas and 4.0 sccm of nitrogen gas were introduced by a mass flow controller as the atmosphere gas, and the growth pressure was 2 x 10⁻² Torr. The SiC substrate was grounded potentially, the voltage applied between the SiC substrate and the Ga metal target was -600 V, the voltage application time was 5 µs, and the voltage application pause time was 95 µs, while the voltage applied between the SiC substrate and the Ga metal target was -557 V, the voltage application time was 5 µs, and the voltage application pause time was 50 µs. This process was repeated. Sputtering discharge was started by temporarily increasing the amount of Ar gas introduced into the growth chamber, and after confirming that the amount of Ar gas and growth pressure had been stabilized at the set values mentioned above, each shutter was opened to form the GaN layer as the second refractive portion R2. The growth temperature was 350°C. In the same or similar way, an Al target could be used to form the AlN layer as the first refractive portion R1. By repeating the above process, the epitaxial DBR composed of 30 pairs of AlN (first refractive portion R1)/GaN (second refractive portion R2) could be formed.

### Example 7

In Examples 1 to 6, the base semiconductor part 8 can be made of GaN; however, the base semiconductor part 8 may be made of InGaN, which is a GaN-based semiconductor. The InGaN layer is laterally disposed at a low temperature below 1000°C, for example. This is because the vapor pressure of indium increases at a high temperature and indium is not effectively taken into the film. The low film formation temperature provides an effect of reducing the interaction between the mask portion 5 and the base semiconductor part 8. Another effect is that InGaN is less reactive to the mask portion 5 (for example, a silicon oxide film or a silicon nitride film) than GaN. When indium is taken into the base semiconductor part 8 at an In composition level of 1% or more, the reactivity with the mask portion 5 is further lowered. As the gallium raw material gas, triethylgallium (TEG) can be used.

### Example 8

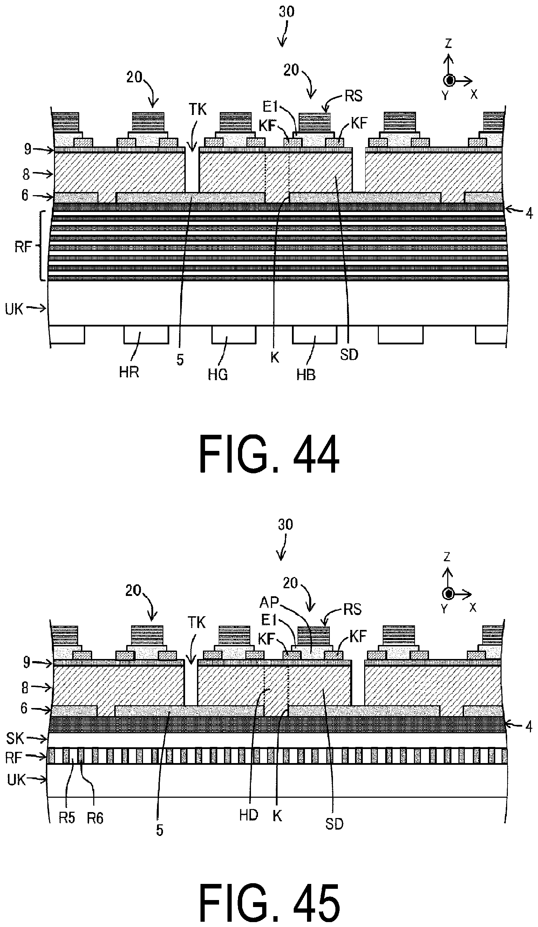

FIGs. 43 and 44 are cross-sectional views each illustrating another configuration of the semiconductor device according to Example 8. As illustrated in FIG. 43, a wavelength conversion portion HS may be provided below (on the back surface side of) the base substrate UK. For example, white illumination can be provided by disposing a typical YAG phosphor or the like that emits yellow light as the wavelength conversion portion HS.

As illustrated in FIG. 44, in the semiconductor device 30 including the plurality of semiconductor laser element 20, a red light emitting phosphor HR is provided to overlap the aperture portion AP in plan view of the semiconductor laser element 20 for the red sub-pixel, a green light emitting phosphor HG is provided to overlap the aperture portion AP in plan view of the semiconductor laser element 20 for the green sub-pixel, and a blue light emitting phosphor HB is provided to overlap the aperture portion AP in plan view of the semiconductor laser element 20 for the blue sub-pixel, thus realizing the semiconductor device 30 for the laser display device.

### Example 9

FIG. 45 is a cross-sectional view illustrating another configuration of the semiconductor device according to Example 9. In FIG. 45, a photonic crystal layer is used for the first light reflector RF. The first light reflector RF, which is a photonic crystal layer, includes, for example, a structure in which a fifth refractive portion R5 and a sixth refractive portion R6 having a refractive index larger than that of the fifth refractive portion R5 are arranged in a two-dimensional (X-Y plane) arrangement. The fifth refractive portion R5 may be a pore (hole) with a diameter of from tens to hundreds of nanometers formed in the base layer in a lattice point pattern. The base layer may be a nitride semiconductor layer. The lattice pitch can be nearly the emission wavelength at the compound semiconductor part 9 (for example, 200 to 400 nm). In this case, the first light reflector RF (photonic crystal layer) with the GaN-based semiconductor layer as the base layer may be formed on the base substrate UK (for example, the GaN substrate), an opposing substrate SK (for example, the GaN substrate) may be disposed on the first light reflector RF, and the first mask 6 may be provided on the opposing substrate SK via the seed portion 4. If the opposing substrate SK is the GaN substrate, the first mask 6 may be provided on the opposing substrate SK. Without providing the opposing substrate SK, the first mask 6 may be provided on the first light reflector RF (photonic crystal layer) via the seed portion 4, or the first mask 6 may be provided on the first light reflector RF (photonic crystal layer). It is known that, when the photonic crystal is formed, the crystallinity of the upper layer decreases. In Example 9, while using the photonic crystal that achieves a high light reflectance, the decrease of crystallinity of the upper layer is suppressed, and the compound semiconductor part 9 with a high light emission efficiency can be obtained.

### Example 10

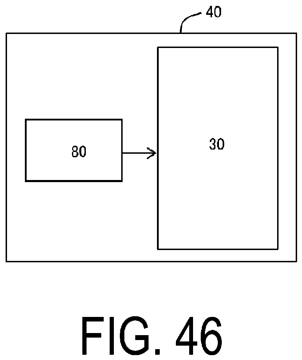

FIG. 46 is a schematic diagram illustrating a configuration of an electronic device according to Example 10. An electronic device 40 in FIG. 46 includes the semiconductor device 30 according to Examples 1 to 9, and a control unit 80 including a processor that controls the semiconductor device 30. Examples of the electronic device 40 include a communication device, an optical device, a display device, an illumination device, a sensor device, an information processing device, a medical device, and an electric vehicle (EV).

The foregoing embodiments and examples have been presented for purposes of illustration and description, and are not intended to be limiting. Based on these illustrations and descriptions, it will be apparent to those skilled in the art that many variations are possible.

### Supplementary Note

In the present disclosure, the invention has been described above based on the various drawings and examples. However, the invention according to the present disclosure is not limited to each embodiment described above. That is, the embodiments of the invention according to the present disclosure can be modified in various ways within the scope illustrated in the present disclosure, and embodiments obtained by appropriately combining the technical means disclosed in different embodiments are also included in the technical scope of the invention according to the present disclosure. In other words, a person skilled in the art can easily make various variations or modifications based on the present disclosure. Note that these variations or modifications are included within the scope of the present disclosure.

### REFERENCE SIGNS

1 Main substrate
2 Buffer portion
3 Base portion
5 Mask portion
6 First mask
8 Base semiconductor part
9 Compound semiconductor part
20 Semiconductor laser element
30 Semiconductor device
RF First light reflector
RS Second light reflector
MS Second mask
R1 to R4 First to fourth refractive portions
UK Base substrate
K Opening portion
Q Opening portion
E1 First electrode
E2 Second electrode
CB Circuit board
HD First portion
SD Second portion

## Claims

1. A semiconductor device, comprising:
a base substrate comprising a main substrate;
a first light reflector located above the base substrate;
a first mask located above the first light reflector;
a base semiconductor part located above the first mask;
a compound semiconductor part located above the base semiconductor part; and
a second light reflector located above the compound semiconductor part and the first light reflector.

2. The semiconductor device according to claim 1, wherein
the first mask comprises a mask portion and an opening portion, and
the base semiconductor part comprises a first portion and a second portion located on the mask portion and having a threading dislocation density of one fifth or less of that of the first portion.

3. The semiconductor device according to claim 2, wherein
the second portion overlaps the first light reflector and the second light reflector in plan view.

4. The semiconductor device according to any one of claims 1 to 3, wherein
the first mask comprises the mask portion and the opening portion, and
the first light reflector comprises a plurality of pairs, each pair comprising a first refractive portion and a second refractive portion having a light refractive index larger than that of the first refractive portion.

5. The semiconductor device according to claim 4, wherein
the second refractive portion comprises a GaN-based semiconductor, and
the first refractive portion comprises a refractive material having a light refractive index smaller than that of the GaN-based semiconductor of the second refractive portion.

6. The semiconductor device according to claim 5, wherein
the refractive material has a thermal conductivity larger than that of the GaN-based semiconductor of the second refractive portion.

7. The semiconductor device according to claim 5 or 6, wherein
the refractive material has a lattice constant smaller than that of the GaN-based semiconductor of the second refractive portion.

8. The semiconductor device according to any one of claims 5 to 7, wherein
a thermal expansion coefficient of the main material of the main substrate < a thermal expansion coefficient of the GaN-based semiconductor of the second refractive portion < a thermal expansion coefficient of the refractive material.

9. The semiconductor device according to any one of claims 5 to 8, wherein
the refractive material is a nitride semiconductor.

10. The semiconductor device according to any one of claims 5 to 9, wherein
the refractive material is AlN, AlInN, or InN.

11. The semiconductor device according to any one of claims 4 to 10, wherein
the mask portion has a light refractive index smaller than that of the second refractive portion.

12. The semiconductor device according to claim 11, wherein
the base semiconductor part has a light refractive index larger than that of the mask portion.

13. The semiconductor device according to any one of claims 4 to 12, wherein
an upper surface of the first light reflector is in the second refractive portion.

14. The semiconductor device according to any one of claims 4 to 13, further comprising:
a seed portion between the first light reflector and the first mask.

15. The semiconductor device according to claim 14, wherein
the seed portion has a light refractive index larger than that of the mask portion and the first refractive portion.

16. The semiconductor device according to any one of claims 2 to 15, wherein
the base semiconductor part is in contact with the upper surface of the first light reflector in the opening portion.

17. The semiconductor device according to claim 4, wherein
the first light reflector is located on the base substrate, and
the base substrate comprises a recessed portion with its upper surface open.

18. The semiconductor device according to claim 17, wherein
the main substrate is recessed at a portion corresponding to the recessed portion.

19. The semiconductor device according to claim 17 or 18, wherein
the base substrate comprises a base portion located above the main substrate, and
the base portion is recessed or penetrated at a portion corresponding to the recessed portion.

20. The semiconductor device according to any one of claims 17 to 19, wherein
the second light reflector overlaps none of the recessed portion in plan view.

21. The semiconductor device according to any one of claims 17 to 20, wherein
the first refractive portion and the second refractive portion comprise a U-shaped portion along the recessed portion.

22. The semiconductor device according to claim 21, further comprising:
a gap in contact with side surfaces of the compound semiconductor part, the base semiconductor part, and the mask portion, and
the gap and the recessed portion overlap in plan view.

23. The semiconductor device according to claim 22, wherein
the U-shaped portion located at the uppermost portion of the first light reflector is in contact with the gap.

24. The semiconductor device according to any one of claims 1 to 23, further comprising:
a base portion located between the main substrate and the first light reflector, and
the base portion comprises a nitride semiconductor.

25. The semiconductor device according to claim 24, further comprising:
a buffer portion located on the main substrate; and
a second mask located between the buffer portion and the base portion.

26. The semiconductor device according to claim 25, wherein
the second mask comprises a mask portion and an opening portion, and
the opening portion of the first mask and the opening portion of the second mask overlap in plan view.

27. The semiconductor device according to claim 25, wherein
the second mask comprises a mask portion and an opening portion, and
a mask center portion of the first mask and the opening portion of the second mask overlap in plan view.

28. The semiconductor device according to claim 2 or 3, further comprising:
a first electrode located above the compound semiconductor part and overlapping the second light reflector in plan view.

29. The semiconductor device according to claim 28, further comprising:
a second electrode located above the first mask or below the main substrate.

30. The semiconductor device according to claim 29, wherein
the second electrode does not overlap the second light reflector in plan view.

31. The semiconductor device according to claim 29 or 30 wherein
the second electrode is in contact with the base semiconductor part.

32. The semiconductor device according to claim 29 or 30, further comprising:
a seed portion between the first light reflector and the first mask, wherein
the second electrode is in contact with the seed portion.

33. The semiconductor device according to claim 29 or 30, wherein
the second electrode is in contact with the upper surface of the first light reflector.

34. The semiconductor device according to claim 29, further comprising:
an insulating film located on the compound semiconductor part, wherein
the insulating film comprises an aperture portion overlapping the first electrode, the first light reflector, the second portion, and the second light reflector in plan view.

35. The semiconductor device according to claim 34, wherein
the first electrode is a transparent electrode located between the compound semiconductor part and the second light reflector,
the first electrode is in contact with the upper surface of the insulating film, and
the first electrode is in contact with the compound semiconductor part in the aperture portion.

36. The semiconductor device according to claim 34 or 35, wherein
the second light reflector is provided in an island shape on the first electrode.

37. The semiconductor device according to any one of claims 34 to 36, wherein
the second electrode overlaps the second portion in plan view.

38. The semiconductor device according to claim 2 or 3, wherein
the compound semiconductor part comprises a first type semiconductor layer, an active layer, and a second type semiconductor layer in this order.

39. The semiconductor device according to claim 38, wherein
the second type semiconductor layer comprises
an aperture portion that overlaps the first light reflector, the second portion, and the second light reflector in plan view, and
a high-resistance portion surrounding the aperture portion and having a current resistance higher than that of the aperture portion.

40. The semiconductor device according to claim 2 or 3, wherein
the base semiconductor part and the compound semiconductor part each comprise a nitride semiconductor.

41. The semiconductor device according to claim 40, wherein
the main substrate is a different substrate having a lattice constant different from that of the base semiconductor part.

42. The semiconductor device according to any one of claims 1 to 41, wherein
the main substrate has a thermal conductivity higher than that of a GaN bulk substrate.

43. The semiconductor device according to any one of claims 1 to 42, wherein
the main substrate is translucent, and
the first light reflector has a light reflectance smaller than that of the second light reflector.

44. The semiconductor device according to any one of claims 40 to 43, wherein
the main substrate is a silicon carbide substrate.

45. The semiconductor device according to claim 14, wherein
the seed portion is provided locally to overlap the opening portion.

46. The semiconductor device according to claim 40, further comprising:
a gap in contact with side surfaces of the base semiconductor part, the compound semiconductor part, and the second light reflector.

47. The semiconductor device according to claim 46, wherein
each of the side surfaces of the base semiconductor part and the compound semiconductor part is a-plane or m-plane of the nitride semiconductor.

48. The semiconductor device according to claim 46 or 47, wherein
the gap and a center of the mask portion overlap in plan view.

49. The semiconductor device according to claim 34 or 39, wherein
the aperture portion overlaps none of the center of the mask portion in plan view.

50. The semiconductor device of claim 49, wherein
the base semiconductor part has a void therein overlapping the center of the mask portion in plan view.

51. The semiconductor device according to claim 2 or 3, wherein
a threading dislocation density in the second portion is 5 x 10⁶/cm² or less.

52. The semiconductor device according to any one of claims 1 to 51, further comprising:
a wavelength conversion unit located below the main substrate.

53. The semiconductor device according to claim 38, wherein
the second light reflector comprises a plurality of pairs of a third refractive portion and a fourth refractive portion having a light refractive index larger than that of the third refractive portion.

54. The semiconductor device according to claim 53, wherein
the third refractive portion and the fourth refractive portion each contain a dielectric material.

55. The semiconductor device according to claim 53 or 54, wherein
the lower surface of the second light reflector is in the third refractive portion,
the upper surface of the second light reflector is in the fourth refractive portion, and
the third refractive portion has a light refractive index smaller than that of the second type semiconductor layer.

56. The semiconductor device according to any one of claims 1 to 3, wherein
the first light reflector is a photonic crystal layer.

57. The semiconductor device according to claim 29, wherein
the first electrode is an anode, and the second electrode is a cathode.

58. The semiconductor device according to any one of claims 1 to 57, further comprising:
one or more surface emitting semiconductor laser elements each comprising the base semiconductor part, the compound semiconductor part, the first light reflector, and the second light reflector.

59. The semiconductor device according to claim 58, further comprising:
a circuit board connecting to the one or more surface emitting semiconductor laser elements.

60. An electronic device comprising:
the semiconductor device according to claim 59.

61. A method for manufacturing the semiconductor device according to any one of claims 1 to 59, comprising:
forming the base semiconductor part by an ELO method.

62. The method for manufacturing the semiconductor device according to claim 61, wherein
the base substrate comprises a base portion, and
the base portion is formed by the ELO method.

63. The method for manufacturing the semiconductor device according to claim 61, wherein
a lowermost portion of the first light reflector is formed by the ELO method.

64. An apparatus for manufacturing the semiconductor device according to any one of claims 1 to 59, wherein
the base semiconductor part is formed by the ELO method.
